(19) Europäisches Patentamt
European Patent Office
Office européen des brevets

(11) **EP 4 772 916 A1**

(12) **EUROPEAN PATENT APPLICATION**
published in accordance with Art. 153(4) EPC

(43) Date of publication:
08.07.2026 Bulletin 2026/28

(21) Application number: 24859633.0

(22) Date of filing: 23.08.2024

(51) International Patent Classification (IPC):
$G02B\ 6/124^{(2006.01)}$    $G02B\ 5/18^{(2006.01)}$
$G02B\ 6/12^{(2006.01)}$    $G02B\ 6/122^{(2006.01)}$
$H01S\ 5/02255^{(2021.01)}$

(52) Cooperative Patent Classification (CPC):
G02B 5/18; G02B 6/12; G02B 6/122; G02B 6/124;
H01S 5/02255

(86) International application number:
PCT/JP2024/029979

(87) International publication number:
WO 2025/047600 (06.03.2025 Gazette 2025/10)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 30.08.2023 JP 2023139935

(71) Applicant: Kyoto University
Kyoto-shi, Kyoto 606-8501 (JP)

(72) Inventors:
• **NODA, Susumu**
Kyoto-shi, Kyoto 606-8501 (JP)
• **INOUE, Takuya**
Kyoto-shi, Kyoto 606-8501 (JP)
• **YOSHIDA, Masahiro**
Kyoto-shi, Kyoto 606-8501 (JP)

(74) Representative: **Hoeger, Stellrecht & Partner
Patentanwälte mbB
Uhlandstrasse 14c
70182 Stuttgart (DE)**

(54) **DIFFRACTION GRATING COUPLER**

(57) A grating coupler (10) is provided with: a grating (12) having a plate-shaped base body (121) and modified refractive index areas (122) which are regions having a refractive index different from that of the base body (121) and periodically arranged in a one-dimensional or two-dimensional form within a predetermined range of the base body (121); and a light reflecting portion (14) provided at an end portion opposite to a light-input portion (13) of the range. The modified refractive index areas (122) have a planar shape which makes an absolute value of a direct coupling coefficient ($\kappa_{1D}$) smaller than $1/L$ which is the reciprocal of a length ($L$) across the range in a first direction (positive x direction) parallel to the base body (121), where the direct coupling coefficient is an index representing the intensity of light traveling in the first direction (positive x direction) from the light-input portion (13) which is a portion of an end portion of the range and reflected into a second direction (negative x direction) different from the first direction (positive x direction) by 180 degrees without being accompanied by a loss of radiation at the modified refractive index areas (122).

Fig. 1

## EP 4 772 916 A1

**Description**

TECHNICAL FIELD

The present invention relates to a grating coupler which optically couples optical integrated circuits, optical fibers or other optical elements with each other, or an optical element with a free space, by means of a diffraction grating.

BACKGROUND ART

A grating coupler which includes a grating consisting of a plate-shaped base body in which areas having a refractive index different from that of the base body ("modified refractive index area") are periodically arranged has conventionally been used. Grooves or holes are typically used as the modified refractive index areas. In this type of grating coupler, among the light inputted (incident) from an end face of the base body, a component of light having a specific wavelength corresponding to the arrangement period of the modified refractive index areas is diffracted and outputted (emitted) from the principal surface of the grating coupler (to be exact, from the surface of the region where the modified refractive index areas are arranged in the base body). Conversely, it is also possible to output, from the end face, a component of light having the specific wavelength among the light inputted from the principal surface. By arranging one optical element at the principal surface and another optical element at the end face of this grating coupler, the light having the specific wavelength inputted from one optical element can be inputted into the other optical element. As another possibility, an optical element may be arranged at the end face of the grating coupler, and the light having the specific wavelength inputted from that optical element can be outputted from the principal surface of the grating coupler into a free space, or the light having the specific wavelength inputted from the free space into the principal surface can be inputted into that optical element. Such an output of light into the free space or an input of light from the free space can be applied in such areas as an optical communication with another optical element separated from the grating coupler through the free space or the sensing of an object separated from the grating coupler through the free space.

In the conventional grating coupler, when light is inputted from the end face, a portion of the inputted light is reflected at the modified refractive index areas, whereby reflected light whose traveling direction is changed by 180 degrees is generated, and this reflected light is emitted from the light-input portion (the aforementioned end face). Such an emission of the reflected light from the light-input portion causes not only a decrease in the output efficiency of the light from the principal surface of the grating but also an entry of light (back) into the optical element located at the light-input portion, which may possibly cause a failure of the optical element. Accordingly, in a grating coupler disclosed in Patent Literature 1, a modified refractive index area whose planer shape does not have a 180-degree rotational symmetry is used to reduce the proportion of the intensity of light which is initially propagated in a first direction parallel to the base body and then reflected at the modified refractive index area into a second direction which is different from the first direction by 180 degrees. In this grating coupler, when an end face of the base body that receives light traveling in the first direction is used as a light-input portion, the (backward) entry of the light into the light-input portion can be suppressed.

It is commonly known that the spread angle of the light emitted from the principal surface of a grating coupler decreases with an increase in the emission area. The smaller the spread angle is, the smaller the area can be within which the emitted light will be incident on another optical element or the sensing target separated from the grating coupler through the free space, whereby the intensity of light per unit area on the incidence area can be increased. However, in conventional grating couplers, inclusive of the one disclosed in Patent Literature 1, the emission of light barely occurs in an area distant from the light-input portion even within the region where the modified refractive index areas are arranged (in other words, the region where the grating is formed) since the intensity of the light emitted from the principal surface exponentially decreases with increasing distance from the light-input portion. Consequently, the effective emission area will be smaller than the entire principal surface of the grating (the region where the modified refractive index areas are arranged), so that the spread angle will be larger.

In order to prevent such a reduction in the effective emission area, there is a need for a grating coupler which can emit light with an approximately uniform intensity without depending on the distance from the light-input portion. According to Non Patent Literature 1, which discloses a grating coupler consisting of a plate member with a plurality of grooves formed at regular intervals, when the ratio of the width of the groove and that of the non-groove portion (duty ratio) has a specific value, a wavenumber region in which two energy bands of light in the grating overlap each other is formed, and when light having a wavelength corresponding to the energy at an end (singularity) of that wavenumber region is inputted into the grating, the light can be emitted from the entire principal surface of the grating without depending on the distance from the light-input portion.

CITATION LIST

PATENT LITERATURE

Patent Literature 1: WO 2023/026712 A

NON PATENT LITERATURE

Non Patent Literature 1: Alexander Yulaev and six other authors, "Exceptional points in lossy media lead to deep polynomial wave penetration with spatially uniform power loss", Nature Nanotechnology, (Great Britain), Nature Research, April 21, 2022, Vol. 17, pp. 583-589
Non Patent Literature 2: Yong Liang and four other authors, "Three-dimensional coupled-wave model for square-lattice photonic crystal lasers with transverse electric polarization: A general approach", Physical Review B, (United States of America), American Physical Society, November 22, 2011, Vol. 84, p. 195119

SUMMARY OF INVENTION

TECHNICAL PROBLEM

The grating coupler disclosed in Non Patent Literature 1 has a low level of light extraction efficiency since more than one half of the light inputted from the light-input portion will be lost without being outputted in a direction perpendicular to the principal surface of the grating.
The problem to be solved by the present invention is to provide a grating coupler which can emit light from the entire principal surface of the grating and can also exhibit a high level of light extraction efficiency.

SOLUTION TO PROBLEM

A grating coupler according to the present invention developed for solving the previously described problem includes:

a grating having a plate-shaped base body and modified refractive index areas which are areas having a refractive index different from the refractive index of the base body and periodically arranged in a one-dimensional or two-dimensional form within a predetermined region of the base body; and
a light-reflecting portion provided at an end portion of the aforementioned region opposite to the light-input portion, where each of the modified refractive index areas has a planer shape which makes the absolute value of a direct coupling coefficient $\kappa_{1D}$ smaller than $1/L$ which is the reciprocal of a length $L$ across the aforementioned region in a first direction parallel to the base body, where the direct coupling coefficient is an index representing the intensity of light traveling in the first direction from a light-input portion which is a portion of an end portion of the aforementioned region and reflected into a second direction different from the first direction by 180 degrees without being accompanied by a loss of radiation at the modified refractive index area.

A modified refractive index area is an area having a refractive index different from that of the base body, as described earlier. It is typically formed by air (hole or groove). As another example, the modified refractive index area may be created by embedding, in the base body, an object made of a material different from that of the base body. The modified refractive index area may be provided through the entire base body in the thickness direction (so that it penetrates the base body) or in only a portion of the base body in the thickness direction. In the latter case, the modified refractive index area may be provided from one principal surface of the base body (so that it only appears on that principal surface and not on the other principal surface) or completely included in the base body (so that it appears on neither of the two principal surfaces of the base body).
The direct coupling coefficient $\kappa_{1D}$ is an index representing the intensity of light which results from a ray of light which directly changes its traveling direction by 180 degrees among the rays of light which travel within the grating in the first direction and are diffracted in a direction of 180 degrees (i.e., reflected). (This ray of light is hereinafter called the "directly reflected light"; the meaning of the term "direct" will be explained later.) It should be noted that the direct coupling coefficient $\kappa_{1D}$ is a complex number, and the coefficients in its real and imaginary parts have the dimension of the reciprocal of length. It should be noted that the complex conjugate $\kappa_{1D}^{*}$ of $\kappa_{1D}$ ($|\kappa_{1D}|=|\kappa_{1D}^{*}|$) will be an index representing the intensity of light traveling in the second direction and directly reflected into the first direction. The direct coupling coefficient $\kappa_{1D}$ depends on the planer shape of the modified refractive index area and can be calculated based on a method described in Non Patent Literature 2. As described in Patent Literature 1, the light resulting from light traveling within a grating and reflected into a direction of 180 degrees includes not only the directly reflected light but also light which changes its traveling direction by 180 degrees while being accompanied by a loss of radiation due to an interaction with light outputted in a direction perpendicular to the principal surface of the grating (i.e., in a direction different from the traveling direction by 90 degrees). (The latter is hereinafter called the "indirectly reflected light".) The directly reflected light dominantly contributes to the reflection in the direction of 180 degrees.

If the intensity of the directly reflected light is too high, the light will be confined within a local area in a direction parallel to the base body. This will cause the intensity of light in the grating to rapidly (exponentially) decrease with increasing distance from the light-input portion, so that the intensity of the emitted light will also rapidly decrease with increasing distance from the light-input portion. Accordingly, in the present invention 1, $|\kappa_{1D}|$ is made to be smaller than $1/L$ so as to reduce the intensity of the directly reflected light so that the degree of decrease in the intensity of light with increasing distance from the light-input portion will be gentler (like a linear function) than in the conventional case.

However, reducing the intensity of the directly reflected light lowers the extraction efficiency of the emitted light since the proportion of the light which passes through the grating without being emitted in a direction perpendicular to the principal surface of the grating increases in the light incident from the light-input portion. It is most likely that this partial passage of the incident light through the grating without being emitted in a direction perpendicular to the principal surface of the grating is the cause of the decrease in the extraction efficiency of the emitted light in Non Patent Literature 1.

Accordingly, in the present invention, a light-reflecting portion is additionally provided at an end portion opposite to the light-input portion of the aforementioned region (i.e., the region where the modified refractive index areas are arranged). Due to this configuration, the light incident from the light-input portion and propagated in the first direction is reflected by the light-reflecting portion and returned to the grating. The incident light is thus prevented from passing through the grating, so that the extraction efficiency of the emitted light can be improved.

The light reflected by the light-reflecting portion travels in the second direction, and the degree of decrease in the intensity of this light becomes gentler with increasing distance from the light-reflecting portion, as in the case of the light traveling in the first direction. Furthermore, when the light traveling in the second direction is observed with reference to the distance from the light-input portion, the intensity of the light gradually increases with increasing distance from the light-input portion. Therefore, the combination of the light inputted from the light-input portion and traveling in the first direction and the light reflected by the light-reflecting portion and traveling in the second direction results in an even gentler change in the intensity of light depending on the position in the grating, so that the light can be emitted from the entire principal surface of the grating.

The value of $|\kappa_{1D}|$ is determined so that $|\kappa_{1D}| \times L$ becomes smaller than one, i.e., $|\kappa_{1D}|$ becomes smaller than $1/L$, in order to weaken the effect of confining the light within the grating in a direction parallel to the base body, where $L$ is the length in the first direction across the region where the modified refractive index areas are arranged (in other words, the region where the grating is formed). The value of $|\kappa_{1D}|$ should preferably be smaller than $1/(2L)$ in order to minimize the reflection loss due to the directly reflected light, and most preferably be zero. When $|\kappa_{1D}|=0$, the distribution of the intensity of light in the grating is the closest to a uniform distribution. For example, $|\kappa_{1D}|=0$ can be achieved in the case where the modified refractive index area consists of the combination of two subareas having the same shape and refractive index, with the two subareas separated from each other in the first direction by a distance which equals a quarter of the wavelength of the light in the grating.

As noted earlier, the directly reflected light dominantly contributes to the light resulting from light traveling within the grating and reflected into the direction of 180 degrees. However, there is also a certain percentage of influence from the indirectly reflected light. Accordingly, the position of the light-reflecting portion should preferably be set so that the indirectly reflected light and the light reflected by the light-reflecting portion are in opposite phase or approximately opposite phase to each other. This cancels the indirectly reflected light, so that the reflection loss due to the indirectly reflected light can be reduced.

The grating coupler according to the present invention may be configured so that an indirect coupling coefficient (non-Hermitian coupling coefficient) $\mu$ has the same value independently of the position in the periodic arrangement of the modified refractive index areas, where the indirect coupling coefficient is an index representing the intensity of light resulting from light traveling in the first direction or the second direction and changing its traveling direction by 180 degrees while being accompanied by a loss of radiation due to an interaction with light emitted in a direction perpendicular to the base body (i.e., the indirectly reflected light mentioned earlier).

With $\mu$ thus having the same value independently of the position, the light can be emitted from the principal surface of the grating with an approximately uniform intensity. Typically, the state in which $\mu$ has the same value independently of the position can be realized by giving the same shape and material (refractive index) to the modified refractive index areas arranged at their respective positions. It should be noted that being "the same value" in the present context includes the case where the value of $\mu$ varies within a range of $\pm20\%$ depending on the position due to the manufacturing error of the modified refractive index areas which inevitably occurs in the production of grating couplers.

Alternatively, the values of $\mu$ at least at two of the positions at which the modified refractive index areas are periodically arranged may be different from each other.

By varying the value of $\mu$ depending on the position in this manner, an intentional variation can be formed in the intensity of light to be emitted from the principal surface of the grating. In order to vary the value of $\mu$ depending on the

position, the shape or/and material of the modified refractive index areas arranged at their respective positions can be changed according to the position. For example, in the case where each modified refractive index area consists of the combination of a first subarea and a second subarea, the value of $\mu$ increases as the ratio of the area $S1$ of the first subarea and the area $S2$ of the second subarea deviates from one (becomes larger or smaller than one). Therefore, the position-dependent variation of the value of $\mu$ can be achieved by arranging, at different positions, modified refractive index areas having different ratios $S1/S2$ of the areas $S1$ and $S2$. The thickness of each modified refractive index area may also be appropriately set in addition to or in place of the area.

In the grating coupler according to the present invention, the light-reflecting portion can be created, for example, by providing, in an area outer than an end of the aforementioned region, a photonic crystal in which the energy of light having a predetermined wavelength falls within a photonic bandgap. A photonic crystal, which is a structure in which the refractive index periodically changes, is characterized in that it blocks light having a wavelength that falls within a specific wavelength band corresponding to the period of the change in refractive index ("photonic bandgap"). The cause of the formation of the photonic bandgap for light in a photonic crystal is similar to that of the formation of an energy gap (bandgap) for electron which has the nature of waves in a solid. A photonic crystal is typically created by periodically arranging modified refractive index areas in a plate-shaped base body, as with the grating in the present invention. In other words, the grating in the present invention is also a kind of photonic crystal. The difference between the grating in the present invention and the photonic crystal forming the light-reflecting portion exists in whether the energy of light at the predetermined wavelength is set through the period of the arrangement of the modified refractive index areas so that the energy falls within a photonic band in which the light concerned can be propagated (grating) or within the photonic band gap (light-reflecting portion).

In the grating coupler according to the present invention, the indirect coupling coefficient $\mu(x)$ at each position $x$ in the first direction and the second direction of the grating should preferably be within a range expressed as follows using a field intensity $E_{RAD}(x)$ of light to be emitted at position $x$:

[Formula 1]

$$\frac{\left|E_{RAD}(x)\right|^2}{4\int_0^L \left|E_{RAD}(x)\right|^2 dx} < \mu(x) < \frac{\left|E_{RAD}(x)\right|^2}{\int_0^L \left|E_{RAD}(x)\right|^2 dx}$$

Most preferably, it should be given by:

[Formula 2]

$$\mu(x) = \frac{\left|E_{RAD}(x)\right|^2}{2\int_0^L \left|E_{RAD}(x)\right|^2 dx}$$

The indirect coupling coefficient $\mu$ depends on the planer shape of the modified refractive index area and can be calculated based on a method described in Non Patent Literature 2. The magnitude of the interaction between the emitted light and the indirectly reflected light changes depending on the value of $\mu$. Therefore, by appropriately setting the value of $\mu$, it is possible to reduce the proportion of the light returning to the light-input portion due to the indirectly reflected light and thereby increase the extraction efficiency of the light emitted in a direction perpendicular to the base body. Consider an example in which the absolute value $|\kappa_{1D}|$ of the direct coupling coefficient is zero, the light-reflecting portion is provided, and $\mu$ has the same value independently of the position (i.e., $E_{RAD}(x)$ is a constant independent of the position). In this case, the extraction efficiency of the emitted light exceeds 50% when the indirect coupling coefficient $\mu$ is within a range of $0.09/L < \mu < 2.91/L$, or exceeds 90% when $\mu$ is within a range of $0.25/L < \mu < 1/L$ which corresponds to the previously described conditions, or equals 100% when $\mu = 0.5/L$.

For convenience, the description so far has assumed that a portion of the end portion of the region where the modified refractive index areas are periodically arranged (grating) is used as the light-input portion and the light inputted from the light-input portion is outputted from the principal surface of the grating. However, the grating coupler according to the present invention can also be used in such a manner that light inputted from the principal surface of the grating is outputted from the light-input portion (i.e., the portion so named for convenience).

The grating coupler according to the present invention may be configured so that an edge-emitting laser is connected to the light-input portion in such a manner that a light-emitting portion of the edge-emitting laser faces the light-input portion. According to this configuration, the laser light generated from the edge-emitting laser can be outputted from the principal surface of the grating coupler. The edge-emitting laser may be integrally formed with the grating coupler, or it may be provided apart from the grating coupler and be connected to this same grating coupler.

Two grating couplers according to the present invention (exclusive of the one which has an edge-emitting laser connected to the light-input portion) can be used as a single grating coupler by arranging those grating couplers so that their respective light-input portions face each other and the first direction of one grating coupler coincides with the second direction of the other grating coupler. According to this configuration, the light inputted from the principal surface of the grating of one grating coupler can be outputted from the light-input portion (i.e., the portion so named for convenience) of the same grating coupler into the light-input portion of the other grating coupler, to be ultimately outputted from the principal surface of the grating of this other grating coupler. In this case, the device can be used as a converter for converting the diameter of a light beam by designing the gratings (i.e., the aforementioned regions) in the two grating couplers to differ from each other in area.

The description so far has been concerned with the case where the light incident from the light-input portion and traveling in the first direction is outputted from the principal surface of the grating in a direction perpendicular to the same surface. Depending on the shape of the modified refractive index area, it is also possible to cause the light incident from the light-input portion and traveling in the first direction to change its traveling direction by 90 degrees within the base body (in a direction parallel to the base body), and to emit the light from an end portion of the grating different from the light-input portion. Such an edge-emission grating coupler includes:

a grating having a plate-shaped base body and modified refractive index areas which are areas having a refractive index different from the refractive index of the base body and periodically arranged in a one-dimensional or two-dimensional form within a predetermined rectangular region of the base body,

where:

one side of the rectangular region is a light-input portion and one side of the same rectangular region perpendicular to the aforementioned one side is a light-emitting portion; and
each of the modified refractive index areas has a planer shape which makes the absolute value of a direct coupling coefficient $\kappa_{1D}$ smaller than $1/L_2$ which is the reciprocal of a length $L_2$ across the aforementioned region in a first direction parallel to the base body, where the direct coupling coefficient is an index representing the intensity of light traveling in the first direction from the light-input portion and reflected into a second direction parallel to the base body and different from the first direction by 180 degrees without being accompanied by a loss of radiation at the modified refractive index areas. According to this configuration, light can be outputted with an approximately uniform intensity from each position in the linear light-emitting portion.

In this type of edge-emission grating coupler, the two sides of the rectangular region other than the light-input portion and the light-emitting portion should preferably be light-reflecting portions. By this configuration, the light inputted from the light-input portion as well as the light resulting from the input light being diffracted by 90 degrees and traveling in the direction opposite to the light-emitting portion can be prevented from passing through the grating and being lost.

This type of edge-emission grating coupler can also be configured so that an edge-emitting laser is connected to the light-input portion in such a manner that a light-emitting portion of the edge-emitting laser faces the light-input portion.

The two types of grating couplers described so far, i.e., the first grating coupler which receives input light from the light-input portion and emits light in a direction perpendicular to the principal surface of the grating, and the edge-emission grating coupler which is the second grating coupler, can be combined to be used as a single grating coupler. Specifically, a configuration can be adopted in which the light-input portion of the first grating coupler has a linear form perpendicular to the first direction, and the light-input portion of the first grating coupler and the light-emitting portion of the second grating coupler face parallel to each other.

According to this configuration, the light inputted from the light-input portion of the second grating coupler is inputted from each position of the linear light-emitting portion of the second grating coupler into the light-input portion of the first grating coupler with an approximately uniform intensity. The light inputted from each position of the latter light-input portion is further outputted in a direction perpendicular to the grating of the first grating coupler with an approximately uniform intensity in the first direction of the first grating coupler. Therefore, the output intensity of the light can be approximately uniform over the planer region of the grating in the first grating coupler.

The grating coupler consisting of the combination of the first grating coupler and the second emission grating coupler can also be configured so that an edge-emitting laser is connected to the light-input portion of the second (edge-emission) grating coupler in such a manner that a light-emitting portion of the edge-emitting laser faces the light-input portion.

ADVANTAGEOUS EFFECTS OF INVENTION

According to the present invention, it is possible to obtain a grating coupler which can emit light from the entire principal surface of the grating and can also exhibit a high level of light extraction efficiency.

BRIEF DESCRIPTION OF DRAWINGS

[Fig. 1] Fig. 1 is a perspective view (a) and a top view (b) showing a grating coupler according to the first embodiment.
[Fig. 2] Fig. 2 is a top view showing a modified example of the grating coupler according to the first embodiment.
[Fig. 3] Fig. 3 is a top view showing another modified example of the grating coupler according to the first embodiment.
[Fig. 4] Fig. 4 is a longitudinal sectional view (a) and a top view (b) showing an operation of the grating coupler according to the first embodiment.
[Fig. 5] Fig. 5 is a graph showing a calculated result of the intensity distribution of emitted light for one modified example of the grating coupler according to the first embodiment.
[Fig. 6] Fig. 6 is top views (a) and (b) showing two more modified examples of the grating coupler according to the first embodiment.
[Fig. 7] Fig. 7 is a photograph (a) showing emitted light taken when light was inputted into the light-input portion of the grating coupler shown in Fig. 6(b), and a photograph (b) showing emitted light taken when light was inputted into the light-input portion of a grating coupler in a comparative example.
[Fig. 8] Fig. 8 is a top view showing a grating coupler according to the second embodiment.
[Fig. 9] Fig. 9 is a photograph showing emitted light taken when light was inputted into the light-input portion of the grating coupler shown in Fig. 8.
[Fig. 10] Fig. 10 is a top view showing a grating coupler according to the third embodiment.
[Fig. 11] Fig. 11 is an enlarged top view of the second modified refractive index areas of the second grating in the grating coupler according to the third embodiment.
[Fig. 12] Fig. 12 is a graph showing a calculated result of the intensity distribution of emitted light for the grating coupler according to the third embodiment.
[Fig. 13] Fig. 13 is a top view showing a grating coupler according to the fourth embodiment.
[Fig. 14] Fig. 14 is an image showing a calculated result of the intensity distribution of emitted light for the grating coupler according to the fourth embodiment.
[Fig. 15] Fig. 15 is an image showing a calculated result of a far-field pattern of emitted light for the grating coupler according to the fourth embodiment.
[Fig. 16] Fig. 16 is a top view (a) of a grating coupler according to the fifth embodiment as well as longitudinal sectional views (b) and (c) showing an operation of the same grating coupler.
[Fig. 17] Fig. 17 is a top view of a grating coupler according to the sixth embodiment.
[Fig. 18] Fig. 18 is a top view showing an incident-portion grating (a), an in-plane 90-degree diffracting-portion grating (b), and an emitting-portion grating (c) in the grating coupler according to the sixth embodiment.
[Fig. 19] Fig. 19 is a perspective view of a model showing an operation of the grating coupler according to the sixth embodiment.
[Fig. 20] Fig. 20 is an image showing (a) the distribution of the design value of an indirect coupling coefficient $\mu$, (b) the distribution of the design value of a 90-degree coupling coefficient $\kappa_{2D}$, and (c) the intensity distribution of emitted light, all of which were calculated for the grating coupler according to the sixth embodiment.
[Fig. 21] Fig. 21 is a conceptual diagram showing a grating coupler according to the seventh embodiment.
[Fig. 22] Fig. 22 is top views showing an incident-portion grating (a), first and second in-plane 90-degree diffracting-portion gratings (b), and an emitting-portion grating (c) in the grating coupler according to the seventh embodiment.
[Fig. 23] Fig. 23 is top views ((a)-(c)) showing examples in which an edge-emitting laser is connected to the light-input portion in each of the grating couplers according to the first through fourth embodiments.

DESCRIPTION OF EMBODIMENTS

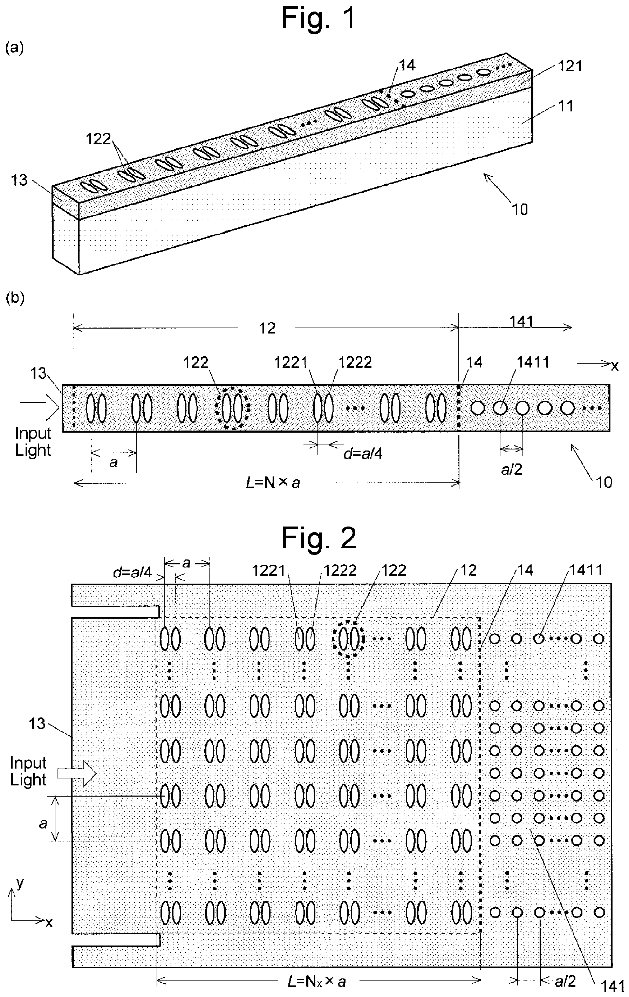

Embodiments of the grating coupler according to the present invention are described using Figs. 1-23.

(1) First Embodiment

Fig. 1 shows a grating coupler 10 according to the first embodiment in (a) a perspective view and (b) a top view. This grating coupler 10 includes: a rectangular plate-shaped base 11; a rectangular plate-shaped base body 121 formed on the surface of the base 11; modified refractive index areas 122 consisting of holes provided in the base body 121; a light-input portion (input port) 13 provided at one of the shorter sides of the rectangle of the base body 121; and a light-reflecting portion 14 provided in the base body 121. The base body 121 and the modified refractive index areas 122 in combination constitute a grating 12. The surface of the base body 121 opposite to the base 11 is a space (air).

In the present embodiment, silicon dioxide ($SiO_2$) is used as the material of the base 11, while silicon (Si) is used as the material of the base body 121. It should be noted that the materials of the base 11 and the base body 121 are not limited to those substances; any material which allows the transmission of light having a wavelength used in the grating coupler can be used for the base body 121, while any material which allows for the creation of the base body 121 on the base 11 and has a lower refractive index than the base body 121 (thereby causing total reflection when light traveling within the base body 121 is incident on the interface with the base 11 at a small angle to the interface) can be used for the base 11. Although the base body 121 in the present embodiment has its bottom entirely supported by the base 11, it is also possible to support the base body 121 only at a portion of its bottom (e.g., only at areas near the two parallel sides of the rectangle of the base body 121) by means of some members. As for the modified refractive index areas 122, a member having a refractive index different from that of the base body 121 may be used in place of the hole.

In the first embodiment, as shown in Fig. 1(b), a large number (*N*) of modified refractive index areas 122 are periodically arranged in a one-dimensional form with period length *a* in a direction in which the longer sides of the rectangle of the base body 121 extend (positive x direction, which corresponds to the first direction mentioned earlier). The modified refractive index areas 122 thus arranged with period length *a* form the grating 12 over a length of *L=N×a*, in which light having wavelength *a* in the grating 12 (the wavelength in vacuum is $a \times n_{eff}$, where $n_{eff}$ is the effective refractive index of the grating 12) will be diffracted in a direction perpendicular to the principal surface of the base body 121. It should be noted that the modified refractive index areas 122 may be arranged in a two-dimensional form, as shown in Fig. 2, instead of being arranged in a one-dimensional form. In the example of Fig. 2, the modified refractive index areas 122 are arranged in a square lattice pattern in which $N_x$ modified refractive index areas are arranged in the direction from the light-input portion 13 toward the light-reflecting portion 14 (positive x direction = first direction) with period length *a*, while $N_y$ modified refractive index areas are arranged in the y direction perpendicular to the x direction with period length *a*.

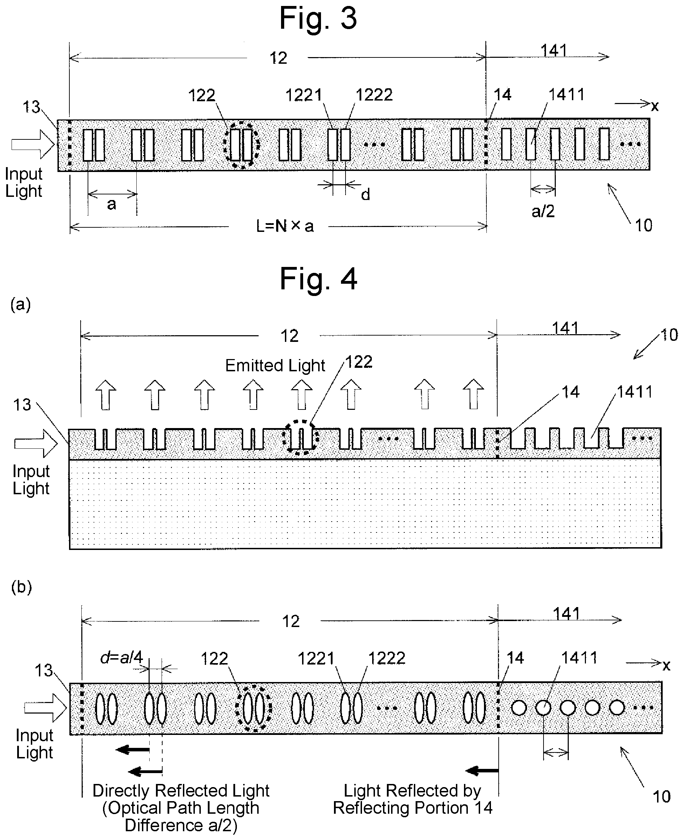

Each individual modified refractive index area 122 consists of a first partial modified refractive index area 1221 and a second partial modified refractive index area 1222 having the same shape and size as the first partial modified refractive index area 1221, which are arranged in the direction from the light-input portion to the light-reflecting portion 14 (x direction), being separated by an approximate distance of *d=a/4*. This results in a direct coupling coefficient of $\kappa_{1D}=0$ (as will be described later in detail). In the present embodiment, the first partial modified refractive index areas 1221 and the second partial modified refractive index areas 1222 have an elliptic planer shape with the shorter diameter coinciding with the x direction. However, their shape is not limited to this example. For example, as shown in Fig. 3, 4 it is possible to use first partial modified refractive index areas 1221 and second partial modified refractive index areas 1222 having a rectangular planer shape with the shorter sides coinciding with the x direction.

The light-reflecting portion 14 is created by periodically arranging modified refractive index areas consisting of holes (which are hereinafter called the light-reflecting-portion modified refractive index areas 1411) with a period length of *a/2* in an area of the base body 121 outer than the end portion opposite to the light-input portion 13 of the grating 12. The area where the light-reflecting-portion modified refractive index areas 1411 are arranged in this manner functions as a photonic crystal 141. In the photonic crystal 141, the periodic arrangement of the light-reflecting-portion modified refractive index areas 1411 creates a periodic change in refractive index, whereby light whose wavelength falls within a specific wavelength band (photonic bandgap) is prevented from passing through. In the present embodiment, since the arrangement of the light-reflecting-portion modified refractive index areas 1411 has a period length of *a/2*, the wavelength *a* within the photonic crystal 141 falls within the photonic bandgap, so that the light having a wavelength of *a* cannot pass through this photonic crystal. Therefore, the light of wavelength *a* traveling within the grating 12 will be reflected by the light-reflecting portion 14 which forms the boundary between the grating 12 and the photonic crystal 141. It should be noted that the period length of the arrangement of the light-reflecting-portion modified refractive index areas 1411 is not limited to *a/2*; it may be appropriately set so that wavelength *a* will fall within the photonic bandgap.

An operation of the grating coupler 10 according to the present invention is described. When the grating coupler 10 is in use, input light having a wavelength of $a \times n_{eff}$ in vacuum, emitted from a light source (not shown), is inputted from the light-input portion 13 in a direction parallel to the base body 121 (first direction). The light inputted into the grating coupler 10 is diffracted by the periodically arranged modified refractive index areas 122 within the grating 12. Since the wavelength in the grating 12 is equal to the period length *a*, the light diffracted in a direction perpendicular to the base body 121 is intensified by interference. Consequently, the light diffracted in a direction perpendicular to the base body 121 is extracted from the principal surface of the base body 121 as emitted light (Fig. 4).

In the case of a conventional grating coupler, the light inputted in a direction parallel to the base body is diffracted by the periodically arranged modified refractive index areas 122 not only into a direction perpendicular to the base body but also into a direction of 180 degrees (i.e., reflected). In contrast, in the grating coupler 10 according to the present embodiment, since the first partial modified refractive index area 1221 and the second partial modified refractive index area 1222 have the same shape and size and are separated by an approximate distance of $d=a/4$, the ray of light directly reflected (without undergoing any interaction other than the reflection) by the first partial modified refractive index area 1221 into the direction of 180 degrees and the ray of light directly reflected by the second partial modified refractive index area 1222 in the direction of 180 degrees are identical in intensity, with an optical path difference of approximately $a/2$ formed between the two rays of light. Consequently, the two rays of directly reflected light cancel each other by interference, so that no directly reflected light is generated. That is to say, the direct coupling coefficient $\kappa_{1D}$ in the present embodiment is zero.

The generation of directly reflected light is thus prevented in the grating coupler 10 according to the present embodiment. This prevents the confinement of light within a range near the light-input portion 13 in the direction parallel to the base body 121, which in turn prevents the intensity of light in the grating from decreasing with increasing distance from the light-input portion. Consequently, the intensity of the light emitted in a direction perpendicular to the base body 121 will also be prevented from decreasing with increasing distance from the light-input portion and will be approximately uniform independently of the position.

Although the direct coupling coefficient $\kappa_{1D}$ is set to zero in the grating coupler 10 according to the present embodiment, a direct coupling coefficient whose absolute value $|\kappa_{1D}|$ is slightly larger than zero can still prevent, to a certain extent, the confinement of light within a range near the light-input portion 13, and can thereby reduce, to a certain extent, the decrease in the intensity of the emitted light with increasing distance from the light-input portion. Specifically, any value of $|\kappa_{1D}|$ smaller than $1/L$ is allowed, where $L$ is the length in the x direction of the grating 12. The direct coupling coefficient $|\kappa_{1D}|$ becomes larger than zero if the distance $d$ between the first partial modified refractive index area 1221 and the second partial modified refractive index area 1222 deviates from $a/4$, or if the first partial modified refractive index area 1221 and the second partial modified refractive index area 1222 are not identical in shape or size. However, such a discrepancy of distance $d$ or difference in shape or size between the first and second partial modified refractive index areas 1221 and 1222 is still allowed as long as it is insignificant and $|\kappa_{1D}|$ can be reduced to be smaller than $1/L$.

On the other hand, no generation of the directly reflected light means that a higher proportion of the input light will reach the end portion opposite to the light-input portion 13 of the grating 12. If the light thus reaching the end portion were allowed to directly pass through, the intensity of the light emitted in a direction perpendicular to the base body 121 would be lower (although an approximately position-independent uniformity could be achieved). By comparison, in the present embodiment, since the light-reflecting portion 14 for reflecting light having a wavelength of $a$ within the grating 12 is provided at the aforementioned end portion, the input light having that wavelength can be reflected by the light-reflecting portion 14 and returned to the grating 12. This prevents the decrease in the extraction efficiency of the emitted light.

The light which changes its traveling direction by 180 degrees from one direction parallel to the base body 121 includes not only the directly reflected light described so far, but also indirectly reflected light, i.e., a ray of light which changes its traveling direction by 180 degrees while being accompanied by a loss of radiation due to the interaction with the light emitted in a direction perpendicular to the base body 121. The intensity of the indirectly reflected light can be calculated from an indirect coupling coefficient $\mu$ which depends on the planer shape of the modified refractive index area 122 (this coefficient can be calculated based on a method described in Non Patent Literature 2). By finely adjusting the position of the light-reflecting portion 14 in the one aforementioned direction, the indirectly reflected light can be cancelled by the light reflected by the light-reflecting portion 14, whereby the proportion of the light returning to the light-input portion 13 can be lowered and the extraction efficiency of the emitted light can be further improved.

In general, in a grating coupler having a direct coupling coefficient $\kappa_{1D}$ and an indirect coupling coefficient $\mu$ (in the present embodiment, it is assumed that both $\kappa_{1D}$ and $\mu$ are independent of position $x$; i.e., each coefficient has the same value at all modified refractive index areas), the intensity $R(x)$ of a progressive wave traveling in the same direction as the traveling direction of the light inputted from the light-input portion (positive x direction = first direction) and the intensity of a retrogressive wave $S(x)$ traveling in the direction different from the progressive wave by 180 degrees (negative x direction = second direction) are expressed by the following propagation equation (1), while the intensity $E_{RAD}(x)$ of the emitted light is expressed by the following equation (2):

[Formula 3]

$$\frac{\partial}{\partial x}\begin{pmatrix} R(x) \\ -S(x) \end{pmatrix} = i\left[\begin{pmatrix} 0 & \kappa_{1D} \\ \kappa_{1D}^{*} & 0 \end{pmatrix} + i\begin{pmatrix} \mu & \mu \\ \mu & \mu \end{pmatrix}\right]\begin{pmatrix} R(x) \\ S(x) \end{pmatrix} \quad \cdots(1)$$

[Formula 4]

$$E_{RAD}(x) = \sqrt{2\mu}\,(R(x) + S(x)) \quad \cdots(2)$$

In the present embodiment, since the direct coupling coefficient $\kappa_{1D}$ (and its complex conjugate $\kappa_{1D}{}^{*}$) is zero, the propagation equation (1) is expressed by the following equation (3):
[Formula 5]

$$\frac{\partial}{\partial x}\begin{pmatrix} R(x) \\ -S(x) \end{pmatrix} = -\mu \begin{pmatrix} 1 & 1 \\ 1 & 1 \end{pmatrix} \begin{pmatrix} R(x) \\ S(x) \end{pmatrix} \quad \cdots(3)$$

If the light-reflecting portion 14 were not present, the solution of equation (3) would be given by:
[Formula 6]

$$\begin{pmatrix} R(x) \\ S(x) \end{pmatrix} = E_0 \begin{pmatrix} \dfrac{\mu(L-x)+1}{\mu L+1} \\ -\dfrac{\mu(L-x)}{\mu L+1} \end{pmatrix} \quad \cdots(4)$$

where $E_0$ is a constant. In that case, the intensity $E_{RAD}$ of the emitted light is given by:
[Formula 7]

$$E_{RAD} = \frac{\sqrt{2\mu}\, E_0}{\mu L+1} \quad \cdots(5)$$

In contrast, in the case where the light-reflecting portion 14 is provided as in the present embodiment and the reflection phase is adjusted so that the light reflected by the light-reflecting portion 14 and the indirectly reflected light cancel each other, the solution of equation (3) is given by:
[Formula 8]

$$\begin{pmatrix} R(x) \\ S(x) \end{pmatrix} = E_0 \begin{pmatrix} \dfrac{2\mu(L-x)+1}{2\mu L+1} \\ -\dfrac{2\mu(L-x)-1}{2\mu L+1} \end{pmatrix} \quad \cdots(6)$$

In that case, the intensity $E_{RAD}$ of the emitted light is given by:
[Formula 9]

$$E_{RAD} = \frac{2\sqrt{2\mu}\, E_0}{2\mu L+1} \quad \cdots(7)$$

Thus, the intensity $E_{RAD}(x)$ of the emitted light will be a constant independent of $x$ (regardless of whether or not the light-reflecting portion 14 is present). That is to say, the intensity of the emitted light will theoretically be uniform independently of the position.
Furthermore, a vertical diffraction efficiency $\eta$ which represents the extraction efficiency of the emitted light (the intensity of the emitted light relative to that of the input light) was calculated as follows: If the light-reflecting portion 14 is not present, equation (4) is applied in $\eta = 1 - (R(L)/E_0)^2 - (S(0)/E_0)^2$ to obtain:
[Formula 10]

$$\eta = \frac{2\mu L}{(\mu L+1)^2} \quad \cdots(8)$$

where $(R(L)/E_0)^2$ is the loss due to the light traveling in the first direction and passing through the end portion opposite to the light-input portion 13, while $(S(0)/E_0)^2$ is the loss due to the light traveling in the second direction and passing through the light-input portion 13. If the light-reflecting portion 14 is provided as in the present embodiment, equation (6) is applied in $\eta=1-(S(0)/E_0)^2$ (note that $(R(L)/E_0)^2=0$ since the light-reflecting portion 14 is present) to obtain:
[Formula 11]

$$\eta \;=\; \frac{8\mu L}{(2\mu L + 1)^2} \quad \cdots(9)$$

Both of these equations (8) and (9) are functions with $\mu L$ as the variable. Subtracting the left side of equation (8) from the right side of equation (9) gives:

[Formula 12]

$$\frac{2\mu L\,(4\mu L + 3)}{(2\mu L + 1)^2 \;\cdot\; (\mu L + 1)^2}$$

which has a positive value regardless of the value of $\mu L$ (both $\mu$ and $L$ are positive). In other words, equation (9) has a larger value of $\eta$ over the entire range of $\mu L$. Accordingly, due to the provision of the light-reflecting portion 14, the grating coupler 10 according to the present embodiment can emit light with a higher level of efficiency than in the case where the light-reflecting portion 14 is not present. For example, when the light-reflecting portion 14 is not present, the vertical diffraction efficiency $\eta$ cannot exceed 0.5 (when $\mu L=1$, i.e., $\mu=1/L$). By comparison, when the light-reflecting portion 14 is present as in the present embodiment, the vertical diffraction efficiency $\eta$ exceeds 0.5 when $0.09<\mu L<2.91$ ($0.09/L<\mu<2.91/L$), or exceeds 0.9 when $0.25<\mu L<1$ ($0.25/L<\mu<1/L$), or becomes equal to one when $\mu L=0.5$, i.e., when $\mu=1/2L$. Thus, the grating coupler 10 according to the present embodiment can emit light with a maximum efficiency of 100% (with a vertical diffraction efficiency $\eta$ of 1) by adjusting the value of $\mu$ (by setting the shape of the modified refractive index area 122).

For the grating coupler 10 according to the first embodiment, the intensity distribution of the emitted light has been calculated by the FDTD method. The calculation was performed for the grating coupler 10 having the modified refractive index areas 122 each of which consisted of the first partial modified refractive index area 1221 and the second partial modified refractive index area 1222 both having a rectangular shape as shown in Fig. 3. The period length $a$ was assumed to be 750 nm, while the distance $d$ between the first partial modified refractive index area 1221 and the second partial modified refractive index area 1222 was assumed to be 215 nm. The first partial modified refractive index area 1221 and the second partial modified refractive index area 1222 in a plan view had a rectangular shape with the shorter sides measuring 90 nm and the longer sides measuring 220 nm. A total of 42 modified refractive index areas 122 ($N=42$) each consisting of the first partial modified refractive index area 1221 and the second partial modified refractive index area 1222 were arranged in the x direction. Although the distance $d$ in this example is slightly larger than the aforementioned $a/4$ (=187.5 nm), the absolute value $|\kappa_{1D}|$ of the direct coupling coefficient is approximately zero, and furthermore, the indirect coupling coefficient $\mu$ has a value close to 0.5$L$. In the photonic crystal 141 for creating the light-reflecting portion 14, the light-reflecting-portion modified refractive index areas 1411 were identical in shape and size to the first partial modified refractive index areas 1221 and had a period length of 375 nm ($a/2$).

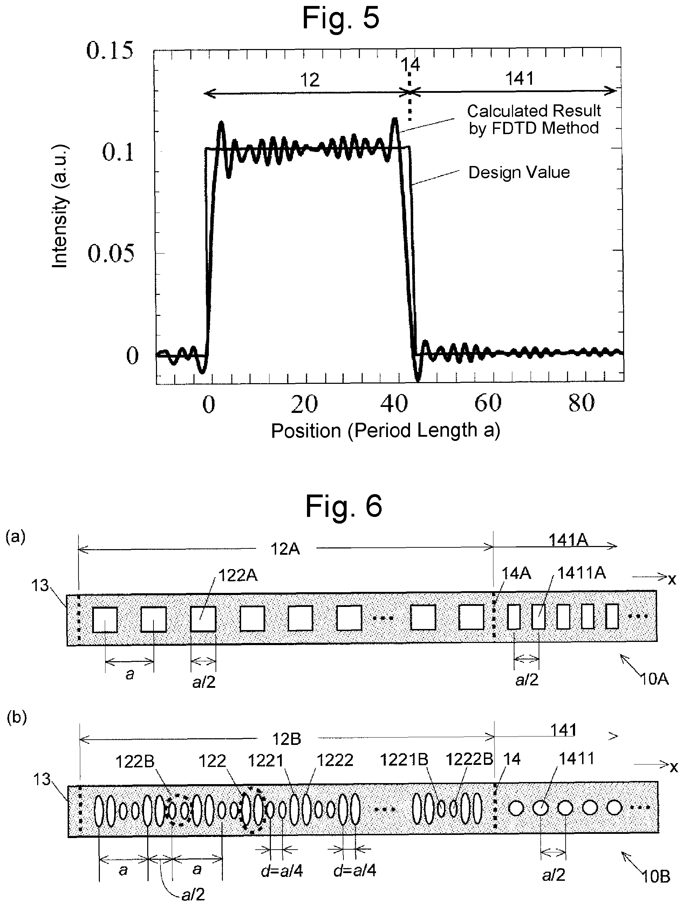

Fig. 5 shows the calculated result. The result demonstrates that the design value is reproduced over the entire grating 12 and the light will be emitted with an approximately uniform intensity independently of the position.

Fig. 6 shows further modified examples of the grating coupler according to the first embodiment.

The grating coupler 10A shown in Fig. 6(a) has a grating 12A in which modified refractive index areas 122A, each of which consists of a single rectangle whose sides in the x direction have a length of $a/2$, are periodically arranged in the x direction with period length $a$. The light-reflecting portion 14A is formed by rectangular light-reflecting-portion modified refractive index areas 1411A periodically arranged in the x direction with period length $a/2$. Other aspects of the configuration are similar to those of the grating coupler 10 according to the first embodiment. Since the sides of the modified refractive index area 122A in the x direction have a length of $a/2$, the configuration of this grating coupler 10A is equivalent to a configuration in which two modified refractive index areas both having a width of $a/4$ in that same direction are arranged at intervals of $a/4$. Therefore, the absolute value $|\kappa_{1D}|$ of the direct coupling coefficient can be sufficiently smaller than $1/L$.

The grating coupler 10B shown in Fig. 6(b) includes a variation of the grating coupler 10 according to the first embodiment and has a grating 12B in which modified refractive index subareas 122B which are different in shape or size from the modified refractive index areas 122 are periodically arranged with period length $a$, with their position shifted from that of the modified refractive index areas 122 by $a/2$ in the x direction. In this modified example, each modified refractive index subarea 122B consists of a first partial modified refractive index subarea 1221B and a second partial modified refractive index subarea 1222B separated by distance $d=a/4$, where the two subareas 1221B and 1222B are identical in shape and size to each other as well as different in shape or size from the first/second partial modified refractive index area 1221/1222. Similar to the case of the first/second partial modified refractive index areas 1221/1222, the present configuration yields a direct coupling coefficient of $\kappa_{1D}=0$ since the directly reflected light at the first partial modified refractive index subareas 1221B and the directly reflected light at the second partial modified refractive index subareas 1222B cancel each other by interference, causing the directly reflected light to be cancelled over the entire grating 12B by interference. On the other hand, the indirect reflection coefficient $\mu$ can be appropriately adjusted through the difference in shape and size between the first/second partial modified refractive index areas 1221/1222 and the first/second modified refractive index subareas 1221B/1222B.

Next, the grating coupler 10B as shown in Fig. 6(b) was created, and an experiment was conducted in which an image of light emitted when light was inputted from the light-input portion 13 was taken. The created grating coupler 10B had a grating 12B consisting of a base body 121 made of silicon measuring 220 nm in thickness and 520 nm in waveguide width, with the modified refractive index areas 122 and the modified refractive index subareas 122B each formed by holes arranged over a range of 175 $\mu$m long with period length $a$=875 nm. The area $S1$ of the modified refractive index area 122 was 11.0% of the area of the unit lattice in the grating 12B (5.5% for each of the first and second partial modified refractive index areas 1221 and 1222), while the area $S2$ of the modified refractive index subarea 122B was 9.2% of the area of the unit lattice (4.6% for each of the first and second partial modified refractive index subareas 1221B and 1222B). For comparison, a similar experiment as conducted for the grating coupler 10B was also performed for a conventional grating coupler, which was created by using a base body having the same material and size as the created grating coupler 10B, in which modified refractive index areas whose planer shape did not have a 180-degree rotational symmetry (with its area being 10% of the area of the unit lattice) as described in Patent Literature 1 were arranged over a range of 175 $\mu$m long with period length $a$=750 nm.

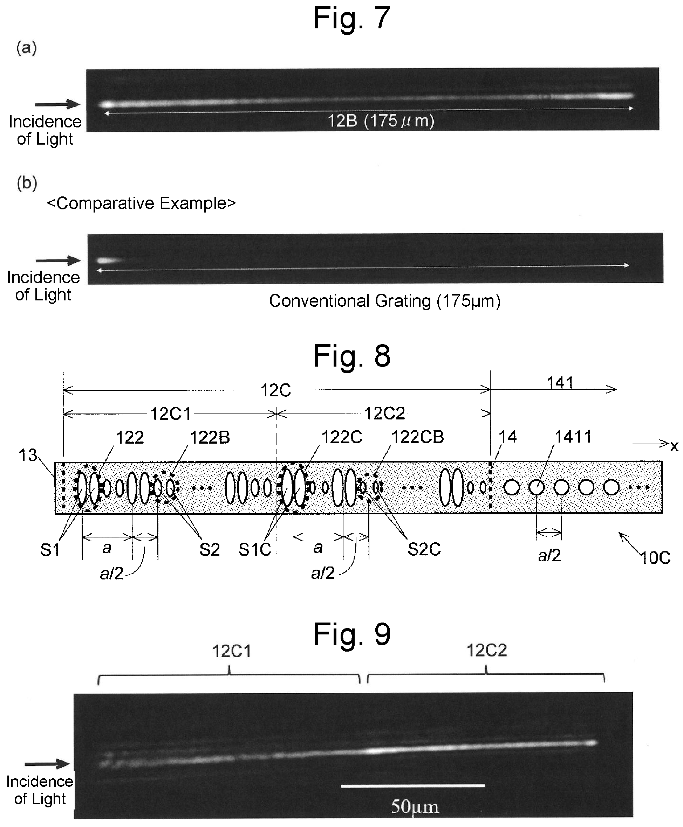

The experimental results for the grating coupler 10B and the conventional grating coupler are shown Figs. 7(a) and 7(b), respectively. Those results demonstrate that, in the conventional grating coupler, the output of light occurred only in an area near the end portion (the left end portion in Fig. 7(b)) of the grating from which the light was inputted, whereas, in the grating coupler 10B, the output of light occurred over the entire grating 12B. Furthermore, the efficiency of the output light from the grating coupler 10B (the proportion of the output light to the input light) was measured, in which a significantly high value of approximately 85% was obtained.

(2) Second Embodiment

The first embodiment assumed that the indirect coupling coefficient $\mu$ had a position-independent value, i.e., it had the same value at all modified refractive index areas. However, it is also possible to give different values to the indirect coupling coefficient $\mu$ depending on the position. Such an example is described in the second embodiment.

For example, consider a grating coupler having a configuration similar to the first embodiment except for the shape of the modified refractive index areas, and assume that the direct coupling coefficient $\kappa_{1D}$ is zero. By varying the value of the indirect coupling coefficient $\mu$ depending on the position $x$ as represented by function $\mu(x)$ included within a range which satisfies the following inequality (10), light can be emitted with a field intensity which changes depending on the position $x$ as expressed by the function $E_{RAD}(x)$ in inequality (10). The function $\mu(x)$ should preferably be expressed by the following equation (10A).

[Formula 13]

$$\frac{\left|E_{RAD}(x)\right|^2}{4\int_0^L \left|E_{RAD}(x)\right|^2 dx} < \mu(x) < \frac{\left|E_{RAD}(x)\right|^2}{\int_0^L \left|E_{RAD}(x)\right|^2 dx} \quad \cdots(10)$$

$$\mu(x) = \frac{\left|E_{RAD}(x)\right|^2}{2\int_0^L \left|E_{RAD}(x)\right|^2 dx} \quad \cdots(10A)$$

The position dependency of the value of $\mu(x)$ can be realized by varying the shape of the modified refractive index areas according to their respective positions in the arrangement. For example, consider the grating coupler 10B shown in Fig. 6(b) in the first embodiment in which the modified refractive index area 122 and the modified refractive index subarea 122B are separated from each other by a distance of $a/2$, with each of the two types of areas arranged with period length $a$. In this case, the value of $\mu$ increases as the ratio of the area $S1$ of the modified refractive index aera 122 to the area $S2$ of the modified refractive index subarea 122B, $S1/S2$, becomes more different from (larger or smaller than) one. Therefore, it is possible to emit light with a different field intensity depending on the position $x$, as expressed by function $E_{RAD}(x)$, by periodically arranging the modified refractive index areas 122 and the modified refractive index subareas 122B whose $S1/S2$ is set for each position so that the value of $\mu$ satisfies inequality (10) (and preferably, equation (10A)).

As an example of the second embodiment, a grating coupler 10C which is a variation of the grating coupler 10B in the first embodiment was created as shown in Fig. 8. Specifically, within a one-dimensional grating 12C, the modified refractive index areas 122 of area $S1$ and the modified refractive index subareas 122B of area $S2$ were arranged in the half section 12C1 located next to the light inputting portion 13 in the x direction, while the modified refractive index areas 122C of area $S1C$ and the modified refractive index subareas 122D of area $S2C$ were arranged in the half section 12C2 located next to the light-reflecting portion 14. The areas of the modified refractive index (sub)areas were set so as to satisfy the condition of $1<(S1/S2)<(S1C/S2C)$, with the value of $\mu$ in the section 12C2 being equal to two times the value of $\mu$ in the section 12C1. Specifically, $S1$=11.4%, $S2$=9.0% ($S1/S2$=1.27), $S1C$=11.8%, and $S2C$=8.6% ($S1C/S2C$=1.37). The thickness (220 nm) and the width (520 nm) of the base body as well as the period length (875 nm) of the arrangement of the modified refractive index (sub)areas were the same values as used in the experiment shown in Fig. 7(a) in the first embodiment.

The experimental result for the created grating coupler 10C is shown in Fig. 9. The emission of light in the section 12C2 farther from the light-input portion 13 was stronger than in the section 12C1 closer to the light-input portion 13 (from which the light entered). Thus, a unique intensity distribution which cannot be obtained with the conventional grating coupler was obtained.

(3) Third Embodiment

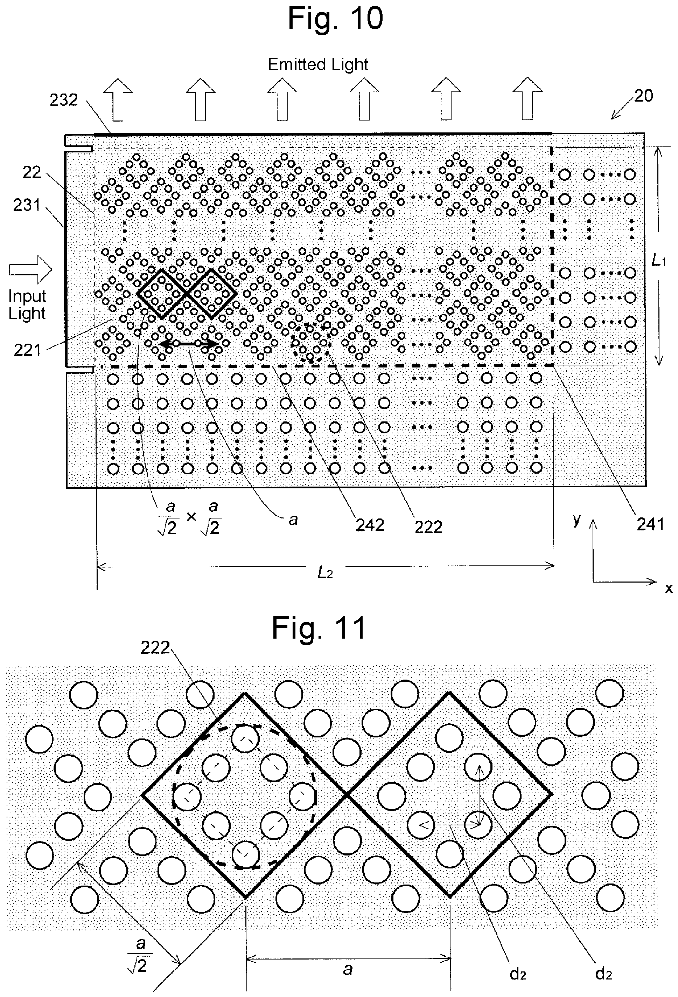

Fig. 10 shows a grating coupler 20 according to the third embodiment in a top view. This grating coupler 20 includes: a rectangular plate-shaped base (not shown, which is located on the back side of the sheet of Fig. 10 as seen from a base body 211, which will be mentioned later); a rectangular plate-shaped base body 221 formed on the surface of the base; modified refractive index areas 222 consisting of holes periodically arranged within a range defined by a rectangle in the base body 221; a linear light-input portion 231 provided at one of the four sides of the aforementioned rectangle; a linear light-emitting portion 232 provided at one (which will be described later) of the two sides perpendicular to the one aforementioned side; a first reflecting portion 241 having a linear form and provided at the side opposite to the side at which the light-input portion 231 is provided; and a second reflecting portion 242 having a linear form and provided at one side opposite to the side at which the light-emitting portion 232 is provided. The principal surface of the base body 221 (the front side of the sheet of Fig. 10) opposite to the base (on the back side of the same sheet) is a space (air). A grating 22 will be formed within the rectangular range where the modified refractive index areas 222 are arranged. The direction perpendicularly extending from the linear light-input portion 231 to the grating is hereinafter defined as the positive x direction, while the direction different from the positive x direction by 90 degrees counterclockwise is defined as the positive y direction. The light-emitting portion 232 is provided at one of the two aforementioned sides which is on the positive side in the y direction.

The modified refractive index areas 222 are arranged at the lattice points of a square lattice which is inclined to the x and y directions by 45 degrees and has a period length of $2^{-1/2}a$. In each of the x and y directions, they are arranged at intervals of $a$. It is commonly known that, in a two-dimensional photonic crystal having modified refractive index areas arranged at the lattice points of such a square lattice, rays of light having a wavelength of $a$ in the two-dimensional photonic crystal (which corresponds to a wavelength of $n_{eff} \times a$ in vacuum, where $n_{eff}$ is the effective refractive index of the grating 22) and traveling in the x and y directions, respectively, will not be emitted in a direction perpendicular to the base body, while they are diffracted in the directions of 180 and 90 degrees, respectively, in the plane parallel to the base body. This similarly applies to the grating 22 in the present embodiment.

Each individual modified refractive index area 222 consists of holes having a circular planer shape as shown in an enlarged view in Fig. 11, including four holes arranged at the corners of a square whose sides are each inclined to the x and y directions by 45 degrees (as indicated by the thin broken line in Fig. 11) as well as four holes arranged at the midpoints of the sides of the same square. The value of the direct coupling coefficient $\kappa_{1D}$ can be changed by adjusting the interval $d_2$ in the x and y directions of the holes arranged at the midpoints of the sides of the square within one modified refractive index area 222. In the present embodiment, the value of the direct coupling coefficient $\kappa_{1D}$ is set to be smaller than $1/L_2$, i.e., the reciprocal of $L_2$ which is the length across the grating 22 in the x direction. For example, $\kappa_{1D}$ will be zero when $d_2$ is $0.254a$ and the radius $r$ of each hole in the modified refractive index area 222 is $0.035a$.

The value of a direct 90-degree diffraction coefficient $\kappa_{2D}$, which is an index representing the intensity of the light diffracted in a direction of 90 degrees in a plane parallel to the base body, also depends on the shape of the modified refractive index area 222. In the previously described example, the value of the direct 90-degree diffraction coefficient $\kappa_{2D}$ can be adjusted through radius $r$. For the present example, it is assumed that radius $r$ has the same value in all modified refractive index areas 222 of the grating 22.

Furthermore, in the grating coupler 20 according to the third embodiment, indirectly reflected light which corresponds to the indirectly reflected light in the grating coupler 10 according to the first embodiment is generated from the light traveling in the positive or negative x direction and changing its traveling direction by 180 degrees while being accompanied by a loss due to an interaction with light traveling in the y direction. An indirect coupling coefficient $\mu_{2D}$ which is an index representing the intensity of this indirectly reflected light should preferably be $0.09/L_2 < \mu_{2D} < 2.91/L_2$, more preferably $0.25/L_2 < \mu_{2D} < 1/L_2$, and most preferably $\mu_{2D} = 1/2L_2$, as with the indirect coupling coefficient $\mu$ in the first embodiment. The value of $\mu_{2D}$ is expressed by $\mu_{2D} = 2(\kappa_{2D})^2 L_1$ using the direct 90-degree diffraction coefficient $\kappa_{2D}$ and the length $L_1$ across the grating 22 in the y direction.

The first reflecting portion 241 is created by arranging, in an area of the grating 22 outer than the same portion 241 (in the positive x direction), a photonic crystal which prevents light having a wavelength of $a$ in the grating 22 from passing through (i.e., that wavelength falls within a photonic bandgap). The second reflecting portion 242 is created by arranging, in an area of the grating 22 outer than the same portion 242 (in the negative y direction), a similar photonic crystal as in the case of the first reflecting portion 241.

As for the modified refractive index area 222, a member having a refractive index different from that of the base body 221 may be used in place of the hole. The planer shape of the modified refractive index area 222 is not limited to the previously described example but may be an arbitrary shape, although the shape needs to have a four-fold rotational symmetry in order to realize a uniform diffraction intensity.

An operation of the grating coupler 20 according to the third embodiment is described. When light which will have a wavelength of $a$ in the grating coupler 20 is inputted from the light-input portion 231 in the positive x direction, a portion of the light is diffracted in the positive y direction or negative y direction within the grating 22 (as noted earlier, the light will not be diffracted in a direction perpendicular to the base body 221). The portion of light which travels in the positive x direction without being diffracted in the y direction is reflected by the first reflecting portion 241 and changes its traveling direction to the negative x direction. While further traveling in the negative x direction, a portion or the entirety of this light is diffracted in the positive y direction or negative y direction. The portion of light diffracted in the positive y direction directly heads for the light-emitting portion 232. On the other hand, the portion of light diffracted in the negative y direction is reflected by the second reflecting portion 242 and changes its traveling direction to the positive y direction to head for the light-emitting portion 232.

Consequently, light is emitted from the light-emitting portion 232. This light will be emitted with an approximately uniform intensity from the entire range of the linear light-emitting portion 232 since the direct coupling coefficient $\kappa_{1D}$ which is sufficiently smaller than $1/L_2$ prevents the light from being confined to a local area near the light-input portion 231 (on the negative side of the x direction) within the grating 22. The extraction efficiency of the emitted light will also be high since the first and second reflecting portions 241 and 242 are provided.

For the grating coupler 20 according to the third embodiment, the intensity distribution of the emitted light has been calculated by the FDTD method. For this calculation, it was assumed that the period length $a$ was 460 nm, $d_2$ was $0.254a$ (=117 nm), and $r$ was $0.035a$ (=16.1 nm). The modified refractive index areas 222 were arranged so that there were 200 areas in the x direction ($L_2$=460 nm×200=92 μm) and 60 areas in the y direction. The direct coupling coefficient $\kappa_{1D}$ in this example is zero, the absolute value of the direct 90-degree diffraction coefficient $\kappa_{2D}$ is 95 cm$^{-1}$, and the absolute value of the indirect coupling coefficient $\mu_{2D}$ is $\mu_{2D} = 2(\kappa_{2D})^2 L_1 = 49$ cm$^{-1}$ (=0.46/$L_2$).

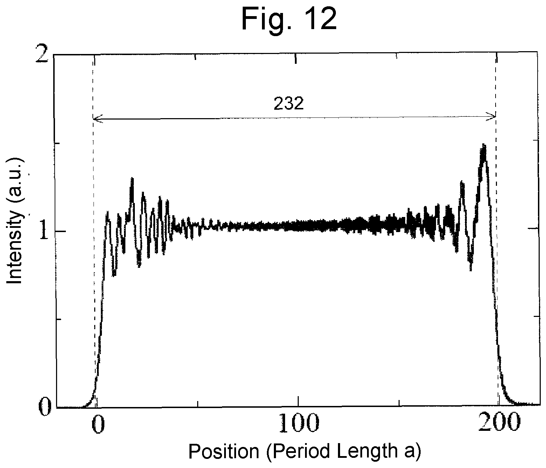

Fig. 12 shows the calculated result. The result demonstrates that light is emitted with an approximately uniform intensity over the entire range of the linear light-emitting portion 232. A calculation of the extraction efficiency of the emitted light yielded a high value of 96%, which was close to 100%.

(4) Fourth Embodiment

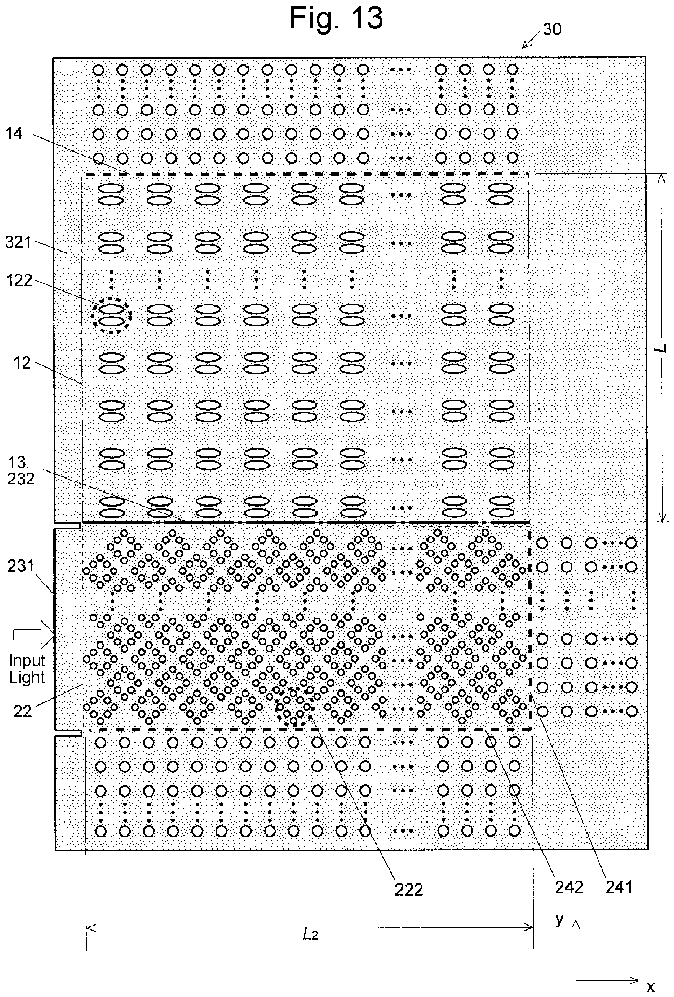

Fig. 13 shows a grating coupler 30 according to the fourth embodiment in a top view. This grating coupler 30 is a combination of the grating coupler 10 according to the first embodiment shown in Fig. 2 (with the modified refractive index areas 122 arranged in a two-dimensional form) and the grating coupler 20 according to the third embodiment shown in Fig. 10. Specifically, the components of the grating coupler 10 according to the first embodiment and those of the grating coupler 20 according to the third embodiment are formed in a single (common) base body 321 in such a manner that the light-emitting portion 232 of the grating coupler 20 is arranged to be coincident with or parallel to the light-input portion 13 of the grating coupler 10. In this grating coupler 30, the light-input portion 231 of the grating coupler 20 according to the third embodiment functions as the light-input portion, while the entire top face of the grating 12 in the first embodiment functions as the light-emitting portion.

An operation of the grating coupler 30 according to the fourth embodiment is described. When light which will have a wavelength of $a$ in the grating coupler 30 is inputted from the light-input portion 231 in the positive x direction, the light is diffracted within the grating 22 as in the grating coupler 20 according to the third embodiment, and the light is inputted from the entire range of the linear light-emitting portion 232 through the light-input portion 13 into the grating 12 with an approximately uniform intensity. Within the grating 12, the light is diffracted in a direction perpendicular to the base body 321 as in the grating coupler 10 according to the first embodiment, to be emitted from the entire planer region of the grating 12 with an approximately uniform intensity.

The intensity distribution of the light emitted from the top face of the grating 12 and a far-field pattern of the emitted light have been calculated for the grating coupler 30 according to the fourth embodiment by a three-dimensional coupled-wave theory described in Non Patent Literature 2. For this calculation, it was assumed that $a$=280 nm (common to both grating couplers 10 and 20), $L$=2.8 mm (10000 modified refractive index areas 122 were arranged in the y direction of the grating 12), and $L_2$=2.8 mm (10000 modified refractive index areas 222 were arranged in the x direction of the grating 22). The planer shape of the modified refractive index area 122 was determined so that $\kappa_{1D}$ would be zero and $\mu$ would be 0.5/$L$. The planer shape of the modified refractive index area 222 was determined so that $\kappa_{1D}$ would be zero and $\mu_{2D}$ would be 0.5/$L_2$.

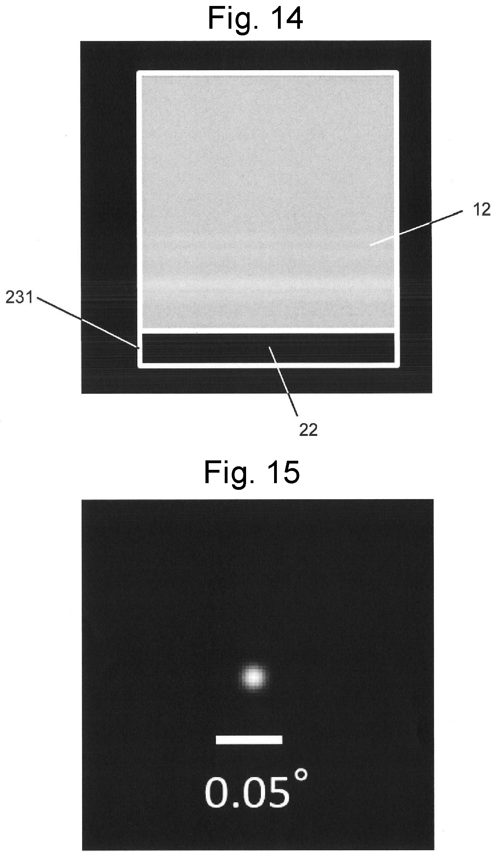

Fig. 14 shows the calculated result of the intensity distribution of the light emitted from the top face of the grating 12, and Fig. 15 shows the calculated result of the far-field pattern of the emitted light. Fig. 14 demonstrates that the light is emitted from the top face of the grating 12 with an approximately uniform intensity independently of the position within the grating 12. Fig. 15 shows that the spread angle of the emitted light is smaller than 0.05 degrees. The reason for the small spread angle of the emitted light is the effective increase in the emission area due to the emission of light with an approximately uniform intensity independently of the position within the grating 12.

(5) Fifth Embodiment

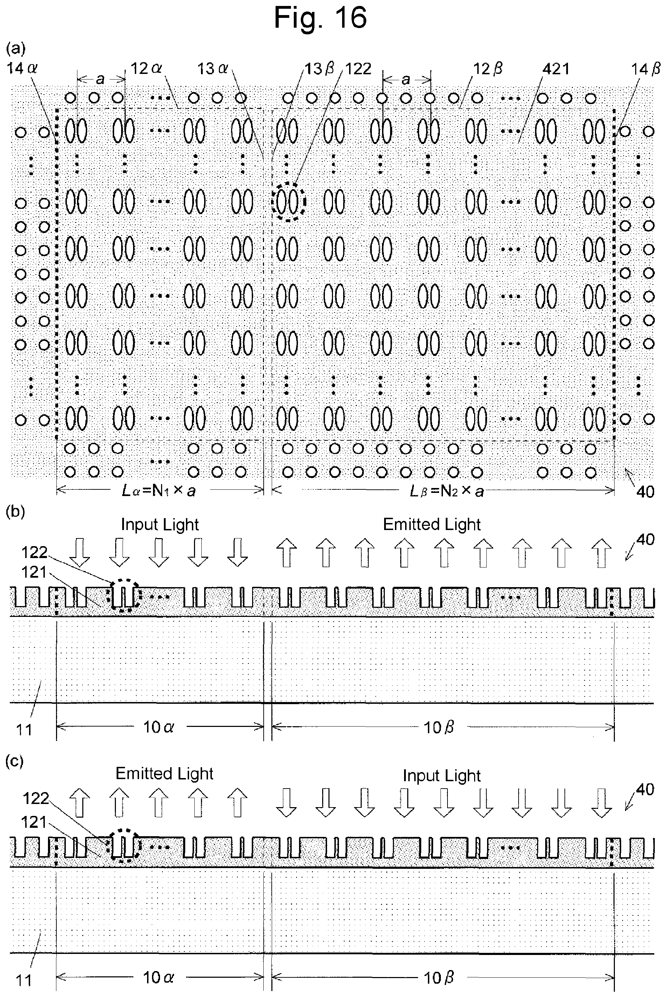

Fig. 16(a) shows a grating coupler 40 according to the fifth embodiment in a top view. This grating coupler 40 includes two grating couplers 10 according to the first embodiment shown in Fig. 2 (with the modified refractive index areas 122 arranged in a two-dimensional form; these two grating couplers are hereinafter called the partial grating couplers 10α and 10β, respectively) formed in a single (common) base body 421 in such a manner that their respective linear light-input portions 13α and 13β are arranged to be coincident with or parallel to each other. It should be noted that each of these light-input portions 13α and 13β receives light emitted from the other light-input portion 13β or 13α; they are not intended to receive light from outside the grating coupler 40.

Although the grating 12α of the partial grating coupler 10α and the grating 12β of the partial grating coupler 10β both consist of modified refractive index areas 122 of the same shape and size arranged with the same period length $a$, the two gratings differ from each other in area. Specifically, both gratings 12α and 12β are rectangular and have the same size in the y direction (in the direction parallel to the light-input portions 13α and 13β) but different lengths $L_1$ and $L_2$ in the x direction. Accordingly, the two gratings have different numbers $N_1$ and $N_2$ of modified refractive index areas 122 forming a row in the x direction.

A light-reflecting portion 14α is provided at the end of the partial grating coupler 10α opposite to the light-input portion 13α. A light-reflecting portion 14β is provided at the end of the partial grating coupler 10β opposite to the light-input portion 13β. These light-reflecting portions 14α and 14β have a configuration similar to the light-reflecting portion 14 in the grating coupler 10 according to the first embodiment.

An operation of the grating coupler 40 according to the fifth embodiment is described using Fig. 16(b). A ray of light which will have a wavelength of $a$ in the grating coupler 40 is inputted from the top face of the grating 12α. Then, within the grating 12α, the light is diffracted by 90 degrees in a direction parallel to the base body 421. Among the rays of diffracted light, the ray of light heading for the light-input portion 13α as well as the ray of light heading for the light-reflecting portion 14α and reflected by the same light-reflecting portion 14α pass through the light-input portion 13α (which is so named for convenience; actually, in this situation, the light is outputted from this light-input portion 13α) and are inputted from the light-input portion 13β into the grating 12β of the partial grating coupler 10β. Within the grating 12β, the light is diffracted by 90 degrees in a direction perpendicular to the base body 421, to be emitted from the entire planer region of the grating 12β with an approximately uniform intensity. Due to the difference in area between the grating 12α and the grating 12β, the light emitted from the grating 12β has a diameter different from that of the light inputted into the grating 12α. That is to say, the grating coupler 40 according to the fifth embodiment functions as a converter which changes the diameter of light.

In the example shown in Fig. 16(b), light is inputted from the top face of the grating 12α and emitted from the top face of the grating 12β. It is also possible to input light from the top face of the grating 12β and emit light from the top face of the grating 12α, as shown in Fig. 16(c). The radius of light will be increased in the example of Fig. 16(b), while the radius of light will be decreased in the example of Fig. 16(c).

(6) Sixth Embodiment

The previously described grating coupler 30 according to the fourth embodiment has the configuration in which the grating 22 (the grating in the third embodiment) which receives light inputted from outside in the x direction and diffracts the light in the y direction (in a direction which is 90 degrees different in the plane) is combined with the grating 12 (the grating in the first embodiment) which receives light inputted from that grating 22 in the y direction and diffracts the light in a direction perpendicular to its principal surface. In this type of configuration, a grating for receiving light in a direction perpendicular to its principal surface and diffracts the light in the x direction may additionally be provided in order to input light into the grating 22 in the x direction. Such an example is described in the sixth embodiment. The following description assumes the use of gratings whose configurations are different from the gratings 22 and 12 used in the fourth embodiment. However, those gratings 22 and 12 can also be used if it is unnecessary to input light with different intensities depending on the positions of incidence and emission as will be described later.

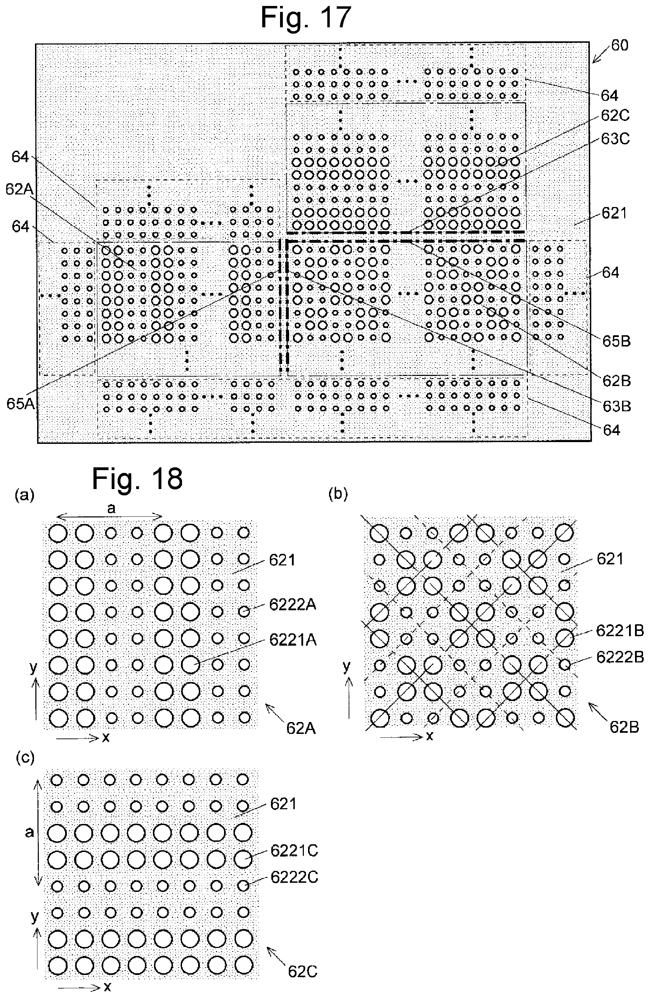

As shown in Fig. 17, the grating coupler 60 according to the sixth embodiment has an incident-portion grating 62A, in-plane 90-degree diffracting-portion grating 62B and emitting-portion grating 62C. Each of these three gratings is provided within a rectangular range in a plate-shaped base body 621. One of the shorter sides of the rectangular range in which the incident-portion grating 62A is provided functions as a first light-output portion 65A having a linear form and configured to output light from the incident-portion grating 62A to the in-plane 90-degree diffracting-portion grating 62B. One of the shorter sides of the rectangular range in which the in-plane 90-degree diffracting-portion grating 62B is provided functions as a second light-input portion 63B having a linear form and configured to input light from the incident-portion grating 62A into the in-plane 90-degree diffracting-portion grating 62B, while one of the longer sides functions as a second light-output portion 65B having a linear form and configured to output light from the in-plane 90-degree diffracting-portion grating 62B to the emitting-portion grating 62C. One of the longer sides of the rectangular range in which the emitting-portion grating 62C is provided functions as a third light-input portion 63C having a linear form and configured to input light from the in-plane 90-degree diffracting-portion grating 62B into the emitting-portion grating 62C. The first light-output portion 65A and the second light-input portion 63B face each other and are substantially parallel to each other. The second light-output portion 65B and the third light-input portion 63C face each other and are substantially parallel to each other. Light-reflecting portions 64 are provided around these three gratings. The configuration of the light-reflecting portions 64 is similar to that of the light-reflecting portion 14 (or the likes) in the previously described embodiments.

Fig. 18 shows the configuration of the incident-portion grating 62A, in-plane 90-degree diffracting-portion grating 62B and emitting-portion grating 62C. As shown in Fig. 18(a), the incident-portion grating 62A consists of a square lattice having lattice points at each of which either a first incident-portion modified refractive index area 6221A or a second incident-portion modified refractive index area 6222A which differ from each other in area is arranged. The first incident-portion modified refractive index areas 6221A and the second incident-portion modified refractive index areas 6222A are respectively arrayed along the y direction (the direction parallel to the first light-output portion 65A) and are also alternately arranged in the x direction (a direction different from the y direction by 90 degrees in the plane) in units of two columns. The intervals of the lattice points in the x direction in the square lattice equals a quarter of the wavelength which the light to be incident on the grating coupler 60 will have in the incident-portion grating 62A. The above configuration creates a periodic structure of four lattice points in the x direction, in which the period length $a$ of the periodic structure equals the wavelength.

As shown in Fig. 18(b), the in-plane 90-degree diffracting-portion grating 62B consists of a square lattice having the same period length as the incident-portion grating 62A and formed by lattice points at each of which either a first in-plane 90-degree diffracting-portion modified refractive index area 6221B or a second in-plane 90-degree diffracting-portion modified refractive index area 6222B which differ from each other in area is arranged. In each of the rows and columns in the x and y directions, two first in-plane 90-degree diffracting-portion modified refractive index areas 6221B neighboring each other and two second in-plane 90-degree diffracting-portion modified refractive index areas 6222B neighboring each other are alternately arranged. Consequently, an array consisting of only the first in-plane 90-degree diffracting-portion modified refractive index areas 6221B (the array indicated by the long-dashed short-dashed line in Fig. 18(b)) and an array consisting of only the second in-plane 90-degree diffracting-portion modified refractive index areas 6222B (the array indicated by the broken line the same figure) are formed every four arrays as viewed in a direction inclined to the x and y directions by 45 degrees.

As shown in Fig. 18(c), the emitting-portion grating 62C has a configuration equivalent to the incident-portion grating 62A rotated about an axis perpendicular to the base body 621 by 90 degrees and extended to cover a wider range. That is to say, first emitting-portion modified refractive index areas 6221C and second emitting-portion modified refractive index areas 6222C which differ from each other in area are respectively arrayed in the x direction and are also alternately arranged in the y direction in units of two rows. It should be noted that the "first light-output portion 65A" in the incident-portion grating 62A and the "third light-input portion 63C" in the emitting-portion grating 62C are so named for convenience; it is possible to have the first light-output portion 65A function as a "light-input portion" and the third light-input portion 63C as a "light-output portion".

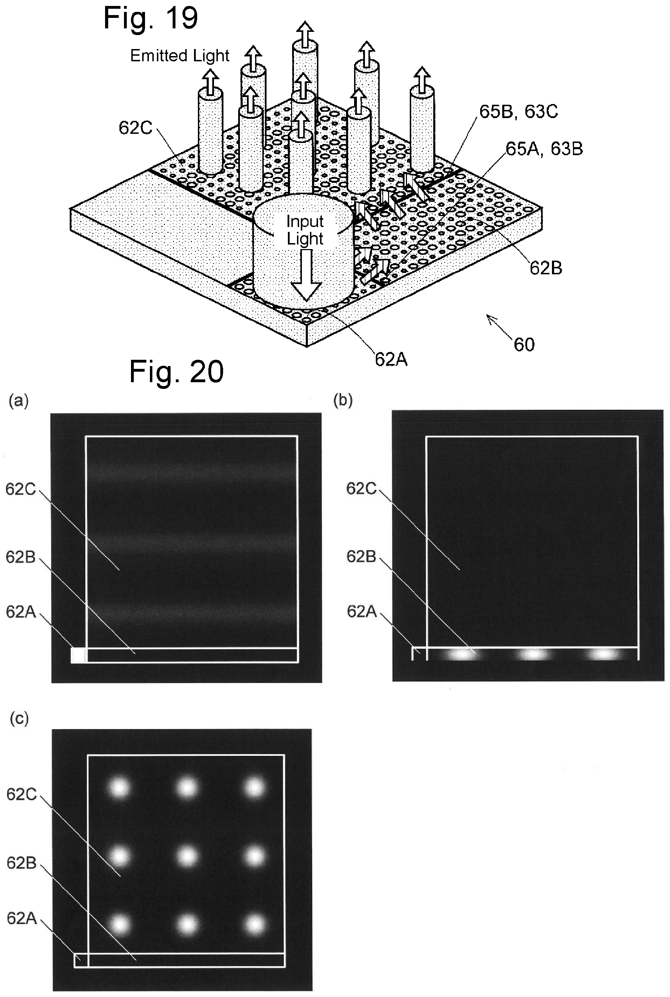

The grating coupler 60 according to the sixth embodiment operates as shown by a model diagram in Fig. 19: When light is incident from the principal surface of the incident-portion grating 62A, a component of light having a wavelength corresponding to the four lattice points among the light propagated in the x direction in the incident-portion grating 62A is inputted into the in-plane 90-degree diffracting-portion grating 62B through the first light-output portion 65A and the second light-input portion 63B while being prevented from being reflected by 180 degrees in the x direction by two first incident-portion modified refractive index areas 6221A having the same area and neighboring each other in the x direction with an interval which equals a quarter of the wavelength (the interval between the neighboring lattice points) as well as by two second incident-portion modified refractive index areas 6222A similarly neighboring each other in the x direction.

In the in-plane 90-degree diffracting-portion grating 62B, the 180-degree reflection of the light propagated in the x direction is similarly prevented due to the reason explained for the incident-portion grating 62A. Meanwhile, when a ray of light propagated in the x direction is reflected (refracted) by 90 degrees in the y direction at a first in-plane 90-degree diffracting-portion modified refractive index area 6221B, the ray of light destructively interferes with another ray of light reflected by 90 degrees in the y direction at a second in-plane 90-degree diffracting-portion modified refractive index area 6222B located at a position displaced from the aforementioned first in-plane 90-degree diffracting-portion modified refractive index area 6221B by one-half waveform (corresponding to two lattice points) in the y direction (a second in-plane 90-degree diffracting-portion modified refractive index area 6222B always exists at the aforementioned position due to the previously described structure of the in-plane 90-degree diffracting-portion grating 62B) since the two rays of light have a phase difference of 180 degrees. However, since the first in-plane 90-degree diffracting-portion modified refractive index area 6221B and the second in-plane 90-degree diffracting-portion modified refractive index area 6222B have different areas, the destructive interference does not cause complete cancellation of the light propagated in the y direction, and the light is inputted into the emitting-portion grating 62C through the second light-output portion 65B and the third light-input portion 63C.

In the emitting-portion grating 62C, a portion of the light inputted from the third light-input portion 63C is reflected into a direction perpendicular to the base body 621 at the first emitting-portion modified refractive index area 6221C or the second emitting-portion modified refractive index area 6222C and is emitted from the principal surface of the emitting-portion grating 62C to the outside.

The other rays of light which are not propagated in any of the aforementioned directions within the incident-portion grating 62A, in-plane 90-degree diffracting-portion grating 62B and emitting-portion grating 62C are reflected by the light-reflecting portions 64 and remain within those gratings. At a later point in time, those portions of light will also be propagated in the previously described manner when their propagating directions are changed to the aforementioned directions through the 90-degree diffraction at the modified refractive index areas (or other processes).

By the operation described so far, the light incident from the principal surface of the incident-portion grating 62A can be emitted from the principal surface of the emitting-portion grating 62C. The intensity of this emitted light can be varied depending on the position in the emitting-portion grating 62C since the two types of modified refractive index areas which differ from each other in area are provided in both the incident-portion grating 62A and the emitting-portion grating 62C.

The intensity of the light emitted from the emitting-portion grating 62C can be set as follows: It is hereinafter assumed that the field intensity distribution $E_{IN}(X, Y)$ of the incident light to be inputted into the incident-portion grating 62A is expressed by:

$$E_{IN}(x, y){=}a(x)b(y) \ldots (11),$$

and the field intensity distribution $E_{RAD}(X, Y)$ of the emitted light to be extracted from the emitting-portion grating 62C is expressed by:

$$E_{RAD}(x, y){=}c(x)d(y) \ldots (12).$$

With these settings, the shape and other parameters of each modified refractive index area are determined so that the direct coupling coefficient $\kappa_{ID}$ will be zero in all gratings while the indirect coupling coefficient $\mu_a(x)$ in the x direction in the incident-portion grating 62A, direct 90-degree diffraction coefficient $\kappa_{2D}(x, y)$ in the in-plane 90-degree diffracting-portion grating 62B, and indirect coupling coefficient $\mu_c(y)$ in the y direction in the emitting-portion grating 62C will have values determined by the following equations (13)-(15), respectively:

[Formula 14]

$$\mu_a(x) = \frac{|a(x)|^2}{2\int_0^L |a(x)|^2 dx} \qquad \cdots(13)$$

$$\kappa_{2D}(x, y) = \frac{|b(y)||c(x)|}{2\sqrt{\int_0^{L1} |b(y)|^2 dy \int_0^{L2} |c(x)|^2 dx}} \qquad \cdots(14)$$

$$\mu_c(y) = \frac{|d(y)|^2}{2\int_0^{L3} |d(y)|^2 dy} \qquad \cdots(15)$$

where $L$ is the length of the incident-portion grating 62A in the x direction, $L1$ and $L2$ are the lengths of the in-plane 90-degree diffracting-portion grating 62B in the y and x directions, respectively, and $L3$ is the length of the emitting-portion grating 62C in the y direction. When these conditions are met, light can be emitted from the emitting-portion grating 62C with a field intensity distribution $E_{RAD}(X, Y)$ which satisfies equation (12) by inputting light into the incident-portion grating 62A with a field intensity distribution $E_{IN}(X, Y)$ which satisfies equation (11).

The field intensity distribution $E_{RAD}(x, y)$ of the light emitted from the principal surface of the emitting-portion grating 62C has been calculated after the shape and other parameters of each modified refractive index area were set so that $a(x)$ would be a function having a single peak, $b(y)$ would be a function having a single peak, $c(x)$ would be a function having three peaks, and $d(y)$ would be a function having three peaks. Fig. 20(a) shows the indirect coupling coefficients $\mu_a(x)$ and $\mu_c(y)$ respectively determined from the herein used $a(x)$ and $d(y)$ by calculations using equations (13) and (15), Fig. 20(b) shows the direct 90-degree diffraction coefficient $\kappa_{2D}(x, y)$ determined from $b(y)$ and $c(x)$ by calculations using equation (14), and Fig. 20(c) shows the field intensity distribution $E_{RAD}(x, y)$ of the emitted light. Fig. 20(c) demonstrates that, in the present example, an emission of light consisting of a total of nine beams arrayed so that there are three beams in the x direction and three beams in the y direction will be emitted from the principal surface of the emitting-portion grating 62C by inputting, from the principal surface of the incident-portion grating 62A, incident light with an intensity distribution having a single peak in the x direction.

(7) Seventh Embodiment

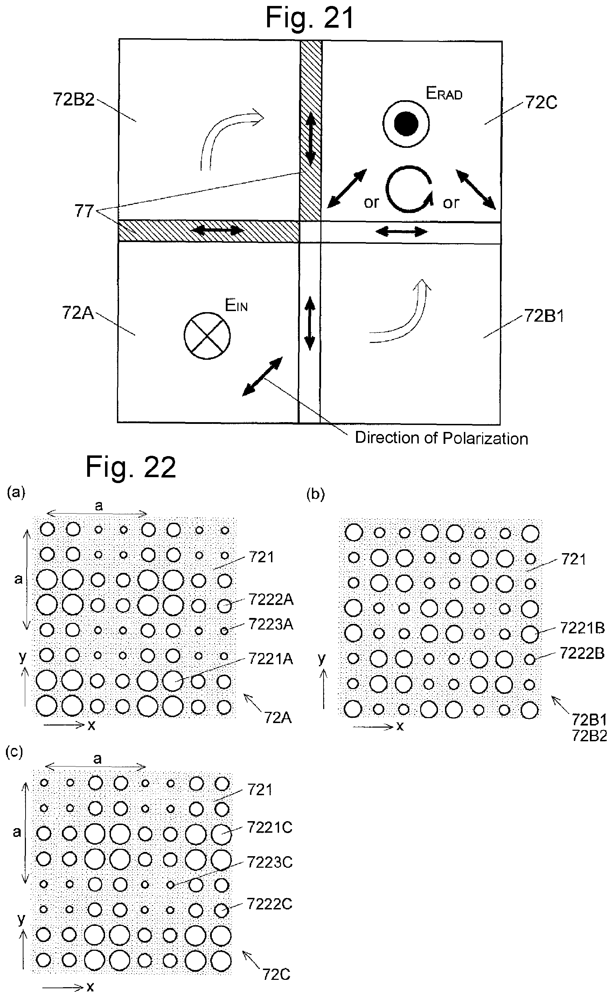

In a grating coupler 70 according to the seventh embodiment, as shown in Figs. 21 and 22, the base body 721 is divided into two regions in the x direction and two regions in the y direction to form a total of four regions, with an incident-portion grating 72A provided in one of the four regions, an emitting-portion grating 72C provided in the region diagonally opposite to the aforementioned region, a first in-plane 90-degree diffracting-portion grating 72B1 provided in the region neighboring the incident-portion grating 72A in the x direction, and a second in-plane 90-degree diffracting-portion grating 72B2 provided in the region neighboring the incident-portion grating 72A in the y direction. Furthermore, phase-adjusting portions 77 are provided between the incident-portion grating 72A and the second in-plane 90-degree diffracting-portion grating 72B2 as well as between the second in-plane 90-degree diffracting-portion grating 72B2 and the emitting-portion grating 72C. Although the phase-adjusting portions 77 in the present embodiment are provided at the two aforementioned locations, it is possible to provide a phase-adjusting portion 77 only at one of those locations. In addition, though not shown, a light-reflecting portion is provided so that it surrounds the four regions combined together.

As shown in Fig. 22(a), the incident-portion grating 72A consists of a square lattice having lattice points at each of which a first incident-portion modified refractive index area 7221A, second incident-portion modified refractive index area 7222A or third incident-portion modified refractive index area 7223A which differ from each other in area is arranged. Two first incident-portion modified refractive index areas 7221A neighboring each other and two second incident-portion modified refractive index areas 7222A neighboring each other are alternately arranged in the x direction. Two second incident-portion modified refractive index areas 7222A neighboring each other and two third incident-portion modified refractive index areas 7223A neighboring each other are alternately arranged in the y direction. The intervals of the lattice points are equal to a quarter of the wavelength which the light to be inputted into the grating coupler 70 will have when the light is in the incident-portion grating 72A. The above configuration creates a periodic structure of four lattice points in each of the x and y directions, in which the period length $a$ of the periodic structure equals the wavelength.

As shown in Fig. 22(b), both the first in-plane 90-degree diffracting-portion grating 72B1 and the second in-plane 90-degree diffracting-portion grating 72B2 have a similar structure to the in-plane 90-degree diffracting-portion grating 62B in the sixth embodiment. In the present embodiment, the two types of modified refractive index areas which differ from each other in area are called the first in-plane 90-degree diffracting-portion modified refractive index area 7221B and the second in-plane 90-degree diffracting-portion modified refractive index area 7222B, respectively.

As shown in Fig. 22(c), the emitting-portion grating 72C has a configuration equivalent to the incident-portion grating 72A rotated about an axis perpendicular to the base body 721 by 90 degrees. The three types of modified refractive index areas in the emitting-portion grating 72C which differ from each other in area are called the first emitting-portion modified refractive index area 7221C, second emitting-portion modified refractive index area 7222C, and third emitting-portion modified refractive index area 7223C.

The phase-adjusting portion 77 has a phase-adjusting area consisting of a portion of the base body 721 and a heater for heating the phase-adjusting area. Heating the phase-adjusting area by the heater changes its temperature and thereby causes a change in the refractive index within the phase-adjusting area. Therefore, it is possible to change the phase of light at the point in time where the light passes through the phase-adjusting area.

An operation of the grating coupler 70 according to the seventh embodiment is described. Linearly polarized light having the aforementioned wavelength and inclined to each of the x and y directions by 45 degrees is inputted into the principal surface of the incident-portion grating 72A. Consequently, within the incident-portion grating 72A, light linearly polarized in the y direction (which is hereinafter called the "y-polarized light") is propagated in the x direction, and light linearly polarized in the x direction (which is hereinafter called the "x-polarized light") is propagated in the y direction. The y-polarized light propagated in the x direction within the incident-portion grating 72A is inputted into the first in-plane 90-degree diffracting-portion grating 72B1 while being prevented from being reflected into the 180-degree direction in a similar manner to the other embodiments. Then, the light is reflected by 90 degrees by the modified refractive index areas in the first in-plane 90-degree diffracting-portion grating 72B1 as in the sixth embodiment and becomes x-polarized light having the direction of polarization changed by 90 degrees, and this light is inputted into the emitting-portion grating 72C. On the other hand, the x-polarized light propagated in the y direction within the incident-portion grating 72A is inputted into the second in-plane 90-degree diffracting-portion grating 72B2 after passing through the phase-adjusting portion 77 while being prevented from being reflected into the 180-degree direction. Then, the light is reflected by 90 degrees by the modified refractive index areas in the second in-plane 90-degree diffracting-portion grating 72B2 and becomes y-polarized light having the direction of polarization changed by 90 degrees, and this light is inputted into the emitting-portion grating 72C after passing through the phase-adjusting portion 77.

Within the emitting-portion grating 72C, the x-polarized light which has thus passed through the first in-plane 90-degree diffracting-portion grating 72B1 is combined with the y-polarized light which has passed through the second in-plane 90-degree diffracting-portion grating 72B2 and the two phase-adjusting portions 77. When there is no phase difference between these two rays of polarized light, the resulting composite light will be linearly polarized light inclined to each of the x and y directions by 45 degrees. On the other hand, when a phase difference is created between the two rays of polarized light due to the effect of the phase-adjusting portions 77, the resulting composite light will be polarized light which reflects that phase difference. For example, when a phase difference of 90 degrees is created between the x-polarized light and the y-polarized light, the resulting composite light will be circularly polarized light. When a phase difference of 180 degrees is created between the x-polarized light and the y-polarized light, the resulting composite light will be linearly polarized light which is 90 degrees inclined to the direction of polarization observed when no phase difference is present. Thus, the grating coupler 70 according to the seventh embodiment functions as a polarization control element for controlling the polarization of the incident light.

A plurality of embodiments of the grating coupler according to the present invention have been described so far. The present invention is not limited to those embodiments and can be changed in various forms.

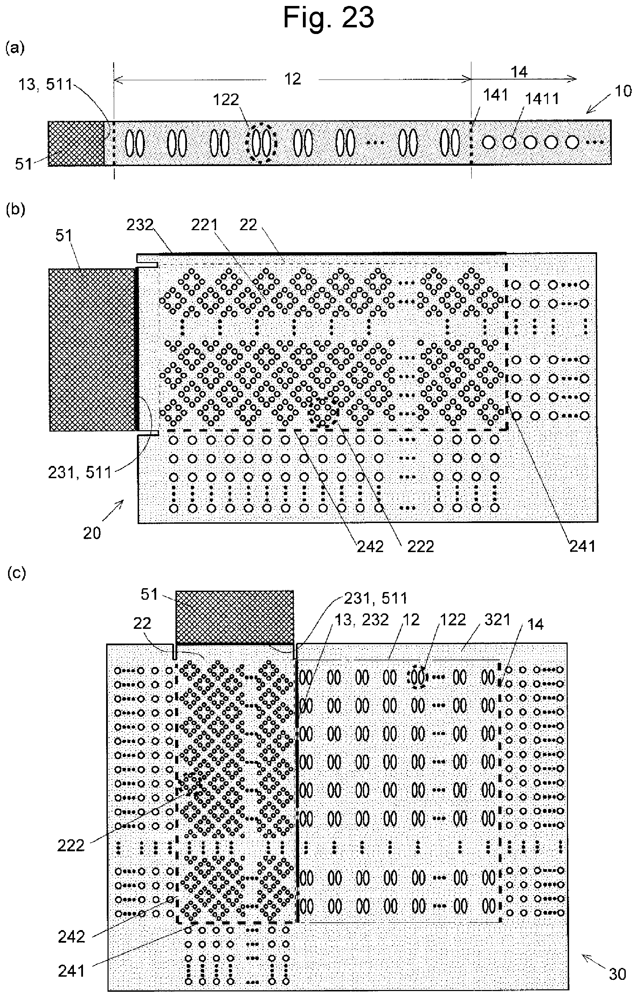

For example, in the grating coupler 10 according to the first embodiment or the grating coupler 10C according to the second embodiment, an end portion 511 of a commonly known edge-emitting laser 51 can be connected to the light-input portion 13 (Fig. 23(a)). The end portion 511 of the edge-emitting laser 51 may also be similarly connected to the light-input portion 231 of the grating coupler 20 according to the third embodiment or the light-input portion 231 of the grating coupler 30 according to the fourth embodiment (Figs. 23(b) and (c)). According to this type of configuration, the laser light generated from the edge-emitting laser 51 is emitted from the principal surface of the grating coupler 10 or 30 or an end portion of the grating coupler 20. Therefore, it is possible to change the emitting direction (in all of the examples mentioned here) or increase the emission area to be larger than the edge of the edge-emitting laser 51 (in the case of the grating coupler 10 or 30).

The edge-emitting laser 51 may be integrated with the grating coupler 10, 20 or 30 by being formed in the base body 121 or 221, for example. Alternatively, the edge 511 of an edge-emitting laser 51 which is separate from the grating coupler 10, 20 or 30 may be connected to the light-input portion 13 or 231. Although the present description concerning the provision of the edge-emitting laser 51 showed only one example for each embodiment, it is possible to similarly connect an edge-emitting laser to the light-input portion in the other examples in the first through fourth embodiments.

[Modes]

It is evident to a person skilled in the art that the previously described illustrative embodiments are specific examples of the following modes of the present invention.

(Clause 1) A grating coupler according to one mode of the present invention includes:

a grating having a plate-shaped base body and modified refractive index areas which are areas having a refractive index different from the refractive index of the base body and periodically arranged in a one-dimensional or two-dimensional form within a predetermined region of the base body; and

a light-reflecting portion provided at an end portion of the aforementioned region opposite to the light-input portion, where each of the modified refractive index areas has a planer shape which makes the absolute value of a direct coupling coefficient $\kappa_{1D}$ smaller than $1/L$ which is the reciprocal of a length $L$ across the aforementioned region in a first direction parallel to the base body, where the direct coupling coefficient is an index representing the intensity of light traveling in the first direction from a light-input portion which is a portion of an end portion of the aforementioned region and reflected into a second direction different from the first direction by 180 degrees without being accompanied by a loss of radiation at the modified refractive index area.

(Clause 2) In the grating coupler according to Clause 2, which is a grating coupler according to Clause 1, an indirect coupling coefficient $\mu$ has the same value independently of the position in the periodic arrangement of the modified refractive index areas, where the indirect coupling coefficient is an index representing the intensity of light resulting from light traveling in the first direction or the second direction and changing its traveling direction by 180 degrees while being accompanied by a loss of radiation due to an interaction with light emitted in a direction perpendicular to the base body.

(Clause 3) In the grating coupler according to Clause 3, which is a grating coupler according to Clause 1, the values of an indirect coupling coefficient $\mu$ at least at two of the positions at which the modified refractive index areas are periodically arranged are different from each other, where the indirect coupling coefficient is an index representing the intensity of light resulting from light traveling in the first direction or the second direction and changing its traveling direction by 180 degrees while being accompanied by a loss of radiation due to an interaction with light emitted in a direction perpendicular to the base body.

(Clause 4) In the grating coupler according to Clause 4, which is a grating coupler according to one of Clauses 1-3, the light-reflecting portion is created by providing, in an area outer than an end of the aforementioned region, a photonic crystal in which the energy of light having a predetermined wavelength falls within a photonic bandgap.

(Clause 5) In the grating coupler according to Clause 5, which is a grating coupler according to one of Clauses 1-4, an indirect coupling coefficient $\mu(x)$ at each position $x$ in the first direction and the second direction of the grating is within a range expressed as follows using a field intensity $E_{RAD}(x)$ of light to be emitted at position x:

[Formula 1]

$$\frac{\left| E_{RAD}(x) \right|^2}{4\int_0^L \left| E_{RAD}(x) \right|^2 dx} < \mu(x) < \frac{\left| E_{RAD}(x) \right|^2}{\int_0^L \left| E_{RAD}(x) \right|^2 dx}$$

where the indirect coupling coefficient $\mu(x)$ is an index representing the intensity of light resulting from light traveling in the first direction or the second direction and changing its traveling direction by 180 degrees while being accompanied by a loss of radiation due to an interaction with light outputted in a direction perpendicular to the base body.

(Clause 6) In the grating coupler according to Clause 6, which is a grating coupler according to one of Clauses 1-5, an edge-emitting laser is connected to the light-input portion in such a manner that a light-emitting portion of the edge-emitting laser faces the light-input portion.

(Clause 7) In the grating coupler according to Clause 7, two grating couplers according to one of Clauses 1-5 are arranged so that their respective light-input portions face each other and the first direction of one grating coupler coincides with the second direction of the other grating coupler.

(Clause 8) A grating coupler according to another mode of the present invention includes:

a grating having a plate-shaped base body and modified refractive index areas which are areas having a refractive index different from the refractive index of the base body and periodically arranged in a one-dimensional or two-dimensional form within a predetermined rectangular region of the base body, where:

one side of the rectangular region is a light-input portion and one side of the same rectangular region perpendicular to the aforementioned one side is a light-emitting portion; and

the modified refractive index areas have a planer shape which makes the absolute value of a direct coupling coefficient $\kappa_{1D}$ smaller than $1/L_2$ which is the reciprocal of a length $L_2$ across the aforementioned region in a first direction parallel to the base body, where the direct coupling coefficient is an index representing the intensity of light traveling in the first direction from the light-input portion and reflected into a second direction parallel to the base body and different from the first direction by 180 degrees without being accompanied by a loss of radiation at the modified refractive index areas.

(Clause 9) In the grating coupler according to Clause 9, which is a grating coupler according to Clause 6, an edge-emitting laser is connected to the light-input portion in such a manner that a light-emitting portion of the edge-emitting laser faces the light-input portion.

(Clause 10) The grating coupler according to Clause 10 includes:

a first grating coupler which is a grating coupler according to one of Clauses 1-5, where the light-input portion has a linear form; and

a second grating coupler which is a grating coupler according to Clause 8 or 9,

where the light-input portion of the first grating coupler and the light-emitting portion of the second grating coupler face parallel to each other.

(Clause 11) The grating coupler according to Clause 11 includes:

a first grating coupler which is a grating coupler according to one of Clauses 1-5, where the light-input portion has a linear form;

a second grating coupler which is a grating coupler according to Clause 8 or 9; and

a third grating coupler which is a grating coupler according to one of Clauses 1-5, where the light-input portion has a linear form,

where:

the light-input portion of the first grating coupler and the light-input portion of the second grating coupler face parallel to each other; and

the light-input portion of the third grating coupler and the light-emitting portion of the second grating coupler face parallel to each other.

In the grating coupler according to Clause 11, the "light-input portion of the first grating coupler" is structurally similar to the light-input portion defined in one of Clauses 1-5 yet actually functions as a light-output portion which outputs light to the light-input portion of the second grating coupler (see the first light-output portion 65A in the sixth embodiment). In the sixth embodiment, the area where the incident-portion grating 62A is formed corresponds to the first grating coupler, the area where the in-plane 90-degree diffracting-portion grating 62B is formed corresponds to the second grating coupler, and the area where the emitting-portion grating 62C is formed corresponds to the third grating coupler.

(Clause 12) The grating coupler according to Clause 12 includes:

a first grating coupler which is a grating coupler according to one of Clauses 1-5, where the modified refractive index areas are arranged in a two-dimensional form, the light-input portion has a linear form, and a second light-input portion having a linear form is additionally provided in a direction different from the light-input portion by 90 degrees;

a second grating coupler which is a grating coupler according to Clause 8 or 9 and has the light-input portion arranged so as to face the light-input portion of the first grating coupler;

a third grating coupler which is a grating coupler according to Clause 8 or 9 and has the light-input portion arranged so as to face the second light-input portion of the first grating coupler;

a fourth grating coupler which is grating coupler according to one of Clauses 1-5, where the modified refractive index areas are arranged in a two-dimensional form, the light-input portion has a linear form, a second light-input portion having a linear form is additionally provided in a direction different from the light-input portion by 90 degrees, the light-input portion is arranged so as to face the light-emitting portion of the second grating coupler, and the second light-input portion is arranged so as to face the light-emitting portion of the third grating coupler; and

a phase-adjusting portion configured to change the phase of passing light, the phase-adjusting portion provided in one or both of an area between the second light-input portion of the first grating coupler and the light-input portion of the third grating coupler and an area between the light-emitting portion of the third grating coupler and the light-input portion of the fourth grating coupler.

The light-input portion and the second light-input portion of the first grating coupler in the grating coupler according to Clause 12 are structurally similar to the light-input portion defined in one of Clauses 1-5 yet actually function as light-output portions which output light to the light-input portions of the second and third grating couplers (the end portions of the incident-portion grating 72A facing the first in-plane 90-degree diffracting-portion grating 72B1 and the second in-plane 90-degree diffracting-portion grating 72B2 in the seventh embodiment correspond to those light-input portions). In the seventh embodiment, the area where the incident-portion grating 72A is formed corresponds to the first grating coupler, the area where the first in-plane 90-degree diffracting-portion grating 72B1 corresponds to the second grating coupler, the area where the second in-plane 90-degree diffracting-portion grating 72B2 is formed corresponds to the third grating coupler, and the area where the emitting-portion grating 72C is formed corresponds to the fourth grating coupler.

REFERENCE SIGNS LIST

10, 10A, 10B, 20, 30, 40, 60, 70 ... Grating Coupler
$10\alpha$, $10\beta$ ... Partial Grating Coupler
11 ... Base
12, 12A, 12A, $12\alpha$, $12\beta$, 22 ... Grating
121, 221, 321, 421, 621, 721 ... Base Body
122, 122A, 222 ... Modified Refractive Index Area
1221 ... First Partial Modified Refractive Index Area
1221B ... First Partial Modified Refractive Index Subarea
1222 ... Second Partial Modified Refractive Index Area
1222B ... Second Partial Modified Refractive Index Subarea
122B ... Modified Refractive Index Subarea
13, $13\alpha$, $13\beta$, 231 ... Light-input portion
14, 14A, $14\alpha$, $14\beta$ ... Light-Reflecting Portion
141 ... Photonic Crystal
1411, 1411A ... Light-Reflecting-Portion Modified Refractive Index Area
232 ... Light-Emitting Portion
241 ... First Reflecting Portion
242 ... Second Reflecting Portion
51 ... Edge-Emitting Laser
511 ... Edge of Edge-Emitting Laser
6221A, 7221A ... First Incident-Portion Modified Refractive Index Area
6221B, 7221B ... First In-Plane 90-Degree Diffracting-Portion Modified Refractive Index Area
6221C, 7221C ... First Emitting-Portion Modified Refractive Index Area
6222A ... Second Incident-Portion Modified Refractive Index Area
6222B, 7222B ... Second In-Plane 90-Degree Diffracting-Portion Modified Refractive Index Area
6222C, 7222C ... Second Emitting-Portion Modified Refractive Index Area
62A, 72A ... Incident-Portion Grating
62B ... In-Plane 90-Degree Diffracting-Portion Grating
62C, 72C ... Emitting-Portion Grating
63B ... Second Light-input portion
63C ... Third Light-input portion
64 ... Light-Reflecting Portion
65A ... First Light-output portion
65B ... Second Light-output portion
72B1 ... First In-Plane 90-Degree Diffracting-Portion Grating
72B2 ... Second In-Plane 90-Degree Diffracting-Portion Grating
7223A ... Third Incident-Portion Modified Refractive Index Area
7223C ... Third Emitting-Portion Modified Refractive Index Area
77 ... Phase-Adjusting Portion

**Claims**

1.   A grating coupler, comprising:

a grating having a plate-shaped base body and modified refractive index areas which are areas having a refractive index different from a refractive index of the base body and periodically arranged in a one-dimensional or two-dimensional form within a predetermined region of the base body; and

a light-reflecting portion provided at an end portion of the aforementioned region opposite to the light-input portion,

where each of the modified refractive index areas has a planer shape which makes an absolute value of a direct coupling coefficient $\kappa_{1D}$ smaller than $1/L$ which is the reciprocal of a length $L$ across the aforementioned region in a first direction parallel to the base body, where the direct coupling coefficient is an index representing the intensity of light traveling in the first direction from a light-input portion which is a portion of an end portion of the aforementioned region and reflected into a second direction different from the first direction by 180 degrees without being accompanied by a loss of radiation at the modified refractive index area.

2. The grating coupler according to claim 1, wherein an indirect coupling coefficient $\mu$ has a same value independently of a position in a periodic arrangement of the modified refractive index areas, where the indirect coupling coefficient is an index representing an intensity of light resulting from light traveling in the first direction or the second direction and changing its traveling direction by 180 degrees while being accompanied by a loss of radiation due to an interaction with light emitted in a direction perpendicular to the base body.

3. The grating coupler according to claim 1, wherein values of an indirect coupling coefficient $\mu$ at least at two of positions at which the modified refractive index areas are periodically arranged are different from each other, where the indirect coupling coefficient is an index representing an intensity of light resulting from light traveling in the first direction or the second direction and changing its traveling direction by 180 degrees while being accompanied by a loss of radiation due to an interaction with light emitted in a direction perpendicular to the base body.

4. The grating coupler according to claim 1, wherein the light-reflecting portion is created by providing, in an area outer than an end of the aforementioned region, a photonic crystal in which an energy of light having a predetermined wavelength falls within a photonic bandgap.

5. The grating coupler according to claim 1, wherein an indirect coupling coefficient $\mu(x)$ at each position $x$ in the first direction and the second direction of the grating is within a range expressed as follows using a field intensity $E_{RAD}(x)$ of light to be emitted at position $x$:

[Formula 1]

$$\frac{\left|E_{RAD}(x)\right|^2}{4\int_0^L \left|E_{RAD}(x)\right|^2 dx} < \mu(x) < \frac{\left|E_{RAD}(x)\right|^2}{\int_0^L \left|E_{RAD}(x)\right|^2 dx}$$

where the indirect coupling coefficient $\mu(x)$ is an index representing an intensity of light resulting from light traveling in the first direction or the second direction and changing its traveling direction by 180 degrees while being accompanied by a loss of radiation due to an interaction with light outputted in a direction perpendicular to the base body.

6. The grating coupler according to claim 1, wherein an edge-emitting laser is connected to the light-input portion in such a manner that a light-emitting portion of the edge-emitting laser faces the light-input portion.

7. A grating coupler, wherein two grating couplers according to one of Clauses 1-5 are arranged so that their respective light-input portions face each other and the first direction of one grating coupler coincides with the second direction of the other grating coupler.

8. A grating coupler, comprising:

a grating having a plate-shaped base body and modified refractive index areas which are areas having a refractive index different from a refractive index of the base body and periodically arranged in a one-dimensional or two-dimensional form within a predetermined rectangular region of the base body,

where:

one side of the rectangular region is a light-input portion and one side of the same rectangular region perpendicular to the aforementioned one side is a light-emitting portion; and

the modified refractive index areas have a planer shape which makes an absolute value of a direct coupling coefficient $\kappa_{1D}$ smaller than $1/L_2$ which is a reciprocal of a length $L_2$ across the aforementioned region in a first direction parallel to the base body, where the direct coupling coefficient is an index representing an intensity of light traveling in the first direction from the light-input portion and reflected into a second direction parallel to the base body and different from the first direction by 180 degrees without being accompanied by a loss of radiation at the modified refractive index areas.

9. The grating coupler according to claim 8, wherein an edge-emitting laser is connected to the light-input portion in such a manner that a light-emitting portion of the edge-emitting laser faces the light-input portion.

10. A grating coupler, comprising:

a first grating coupler which is a grating coupler according to one of claims 1-5, where the light-input portion has a linear form; and
a second grating coupler which is a grating coupler according to claim 8 or 9,
where the light-input portion of the first grating coupler and the light-emitting portion of the second grating coupler face parallel to each other.

11. A grating coupler, comprising:

a first grating coupler which is a grating coupler according to one of claims 1-5, where the light-input portion has a linear form;
a second grating coupler which is a grating coupler according to claim 8 or 9; and
a third grating coupler which is a grating coupler according to one of claims 1-5, where the light-input portion has a linear form,
where:

the light-input portion of the first grating coupler and the light-input portion of the second grating coupler face parallel to each other; and
the light-input portion of the third grating coupler and the light-emitting portion of the second grating coupler face parallel to each other.

12. A grating coupler, comprising:

a first grating coupler which is a grating coupler according to one of claim 1-5, where the modified refractive index areas are arranged in a two-dimensional form, the light-input portion has a linear form, and a second light-input portion having a linear form is additionally provided in a direction different from the light-input portion by 90 degrees;
a second grating coupler which is a grating coupler according to claim 8 or 9 and has the light-input portion arranged so as to face the light-input portion of the first grating coupler;
a third grating coupler which is a grating coupler according to claim 8 or 9 and has the light-input portion arranged so as to face the second light-input portion of the first grating coupler;
a fourth grating coupler which is grating coupler according to one of claims 1-5, where the modified refractive index areas are arranged in a two-dimensional form, the light-input portion has a linear form, a second light-input portion having a linear form is additionally provided in a direction different from the light-input portion by 90 degrees, the light-input portion is arranged so as to face the light-emitting portion of the second grating coupler, and the second light-input portion is arranged so as to face the light-emitting portion of the third grating coupler; and
a phase-adjusting portion configured to change a phase of passing light, the phase-adjusting portion provided in one or both of an area between the second light-input portion of the first grating coupler and the light-input portion of the third grating coupler and an area between the light-emitting portion of the third grating coupler and the light-input portion of the fourth grating coupler.

# Fig. 1

(a)

(b)

# Fig. 2

# Fig. 3

# Fig. 4

(a)

Emitted Light

(b)

Directly Reflected Light
(Optical Path Length
Difference a/2)

Light Reflected by
Reflecting Portion 14

## Fig. 5

## Fig. 6

# Fig. 7

(a)

Incidence of Light

12B (175 μm)

(b)

<Comparative Example>

Incidence of Light

Conventional Grating (175μm)

# Fig. 8

# Fig. 9

12C1    12C2

Incidence of Light

50μm

# Fig. 10

# Fig. 11

# Fig. 12

# Fig. 13

## Fig. 14

## Fig. 15

# Fig. 16

(a)

$$L_\alpha = N_1 \times a \qquad L_\beta = N_2 \times a$$

(b)

Input Light | Emitted Light

(c)

Emitted Light | Input Light

# Fig. 17

# Fig. 18

(a)

(b)

(c)

# Fig. 19

Emitted Light

62C

65B, 63C

65A, 63B

Input Light

62B

62A

60

# Fig. 20

(a)

62C

62B

62A

(b)

62C

62B

62A

(c)

62C

62B

62A

# Fig. 21

Direction of Polarization

# Fig. 22

(a)

(b)

(c)

# Fig. 23

(a)

(b)

(c)

## INTERNATIONAL SEARCH REPORT

| International application No. |
| --- |
| **PCT/JP2024/029979** |

| A. | CLASSIFICATION OF SUBJECT MATTER |
| --- | --- |

*G02B 6/124*(2006.01)i; *G02B 5/18*(2006.01)i; *G02B 6/12*(2006.01)i; *G02B 6/122*(2006.01)i; *H01S 5/02255*(2021.01)i
FI:   G02B6/124; G02B6/12 301; G02B6/122 301; G02B5/18; H01S5/02255

According to International Patent Classification (IPC) or to both national classification and IPC

| B. | FIELDS SEARCHED |
| --- | --- |

Minimum documentation searched (classification system followed by classification symbols)

G02B6/12-6/14; G02B5/18; H01S5/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2023/026712 A1 (KYOTO UNIVERSITY) 02 March 2023 (2023-03-02) entire text, all drawings | 1-12 |
| A | JP 2009-058553 A (UNIV OF TSUKUBA) 19 March 2009 (2009-03-19) entire text, all drawings | 1-12 |
| A | US 2022/0120968 A1 (TAIWAN SEMICONDUCTOR MANUFACTURING CO., LTD.) 21 April 2022 (2022-04-21) entire text, all drawings | 1-12 |
| A | US 2017/0363931 A1 (RUMPF, R. C. et al.) 21 December 2017 (2017-12-21) entire text, all drawings | 1-12 |
| A | JP 2011-096319 A (SONY CORPORATION) 12 May 2011 (2011-05-12) entire text, all drawings | 1-12 |

✓ Further documents are listed in the continuation of Box C.     ✓ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **25 October 2024** | **12 November 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
| :--- |
| **PCT/JP2024/029979** |

### C.    DOCUMENTS CONSIDERED TO BE RELEVANT

| Category* | Citation of document, with indication, where appropriate, of the relevant passages | Relevant to claim No. |
| :---: | :--- | :---: |
| A | WO 2018/179752 A1 (ASAHI KASEI EMD CORPORATION) 04 October 2018 (2018-10-04)<br>  entire text, all drawings | 1-12 |
| A | YULAEV, A. et al. Exceptional points in lossy media lead to deep polynomial wave penetration with spatially uniform power loss. Nature Nanotechnology. 21 April 2022, vol. 17, pp. 583-589, https://doi.org/10.1038/s41565-022-01114-3<br>  entire text, all drawings | 1-12 |
| A | LIANG, Y. et al. Three-dimensional coupled-wave model for square-lattice photonic crystal lasers with transverse electric polarization: A general approach. PHYSICAL REVIEW B. 22 November 2011, vol. 84, no. 19, pp. 195119-1 to 195119-11, 10.1103/PhysRevB.84.195119<br>  entire text, all drawings | 1-12 |

Form PCT/ISA/210 (second sheet) (July 2022)

## INTERNATIONAL SEARCH REPORT
### Information on patent family members

International application No.

**PCT/JP2024/029979**

| Patent document cited in search report | Publication date (day/month/year) | Patent family member(s) | Publication date (day/month/year) |
|---|---|---|---|
| WO 2023/026712 A1 | 02 March 2023 | (Family: none) | |
| JP 2009-058553 A | 19 March 2009 | (Family: none) | |
| US 2022/0120968 A1 | 21 April 2022 | (Family: none) | |
| US 2017/0363931 A1 | 21 December 2017 | (Family: none) | |
| JP 2011-096319 A | 12 May 2011 | (Family: none) | |
| WO 2018/179752 A1 | 04 October 2018 | US 2020/0116631 A1 entire text, all drawings | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2023026712 A

**Non-patent literature cited in the description**

- **ALEXANDER YULAEV**. Exceptional points in lossy media lead to deep polynomial wave penetration with spatially uniform power loss. *Nature Nanotechnology, (Great Britain), Nature Research*, 21 April 2022, vol. 17, 583-589

- Three-dimensional coupled-wave model for square-lattice photonic crystal lasers with transverse electric polarization: A general approach. **YONG LIANG**. Physical Review B. American Physical Society, 22 November 2011, vol. 84, 195119